# EUROPEAN PATENT SPECIFICATION

(11) **EP 3 494 639 B1**
(45) Date of publication and mention of the grant of the patent: **25.02.2026**
(21) Application number: 17754516.7
(22) Date of filing: 25.07.2017
(51) Int. Cl.: H03K 19/0185, H04L 25/02

(54) **IMPEDANCE AND SWING CONTROL FOR VOLTAGE-MODE DRIVER**
IMPEDANZ- UND SCHWINGUNGSSTEUERUNG FÜR SPANNUNGSMODUSTREIBER
COMMANDE D'IMPÉDANCE ET DE COMMUTATION POUR CIRCUIT D'ATTAQUE EN MODE TENSION

(30) Priority: 03.08.2016 US 201615227853; 11.08.2016 US 201615234584; 11.08.2016 US 201615234667
(43) Date of publication of application: 12.06.2019
(73) Proprietor: Xilinx, Inc., San Jose, California 95124 (US)
(72) Inventor: LIM, Siok, Wei, San Jose, CA 95124 (US); CHAN, Kok, Lim, San Jose, CA 95124 (US); TAN, Kee, Hian, San Jose, CA 95124 (US); ZHAO, Hongyuan, San Jose, CA 95124 (US); KOAY, Chin, Yang, San Jose, CA 95124 (US); FRANS, Yohan, San Jose, CA 95124 (US); CHANG, Kun-yung, San Jose, CA 95124 (US); NARANG, Nakul, San Jose, CA 95124 (US)
(74) Representative: Marks & Clerk LLP
(86) International application number: PCT/US2017/043770
(87) International publication number: WO 2018/026578

(56) References cited:
- US-A1- 2008 238 521
- US-A1- 2013 163 126
- US-A1- 2013 343 471
- US-B1- 8 446 173
- US-B1- 9 231 631

## Description

### TECHNICAL FIELD

Examples of the present disclosure generally relate to electronic circuits and, in particular, to impedance and swing control for a voltage-mode driver.

### BACKGROUND

In serial communication systems, a large percentage of the total power is consumed in the transmitter, which must provide for adequate signal swing on a low-impedance channel while maintaining an appropriate source termination. In addition, the transmitter often includes equalization to compensate for frequency- dependent loss in the channel. The driver circuit in the transmitter often consumes the majority of the power of the transmitter. Driver circuits can be implemented as current-mode drivers or voltage-mode drivers. Voltage-mode drivers are known to consume far less power in comparison to current-mode drivers. For example, a voltage-mode driver can consume four times less DC power than a current-mode driver to provide the same output swing.

A voltage-mode driver for a transmitter requires swing and impedance control such that the swing and common-mode/differential-mode return loss are within specifications. One technique for output signal swing control in a driver circuit is to use a single voltage regulator to generate a reference voltage that sets the voltage swing. However, with a single regulator, the common-mode will shift as the output swing of the driver circuit changes. Such a shift in the common-mode can cause the return loss to exceed specifications.

US 8,446,173 B1 describes a high-swing voltage-mode transmitter or line driver. The transmitter can operate over a wide range of supply voltages. Increasing the available output swing merely involves increasing the supply voltage; the circuit adapts to maintain the desired output impedance. This allows for a tradeoff between output amplitude and power consumption. Another advantage of the proposed architecture is that it compensates for process, voltage, and temperature (PVT) and mismatch variations so as to keep rise and fall times matched. This feature reduces common-mode noise and hence EMI in systems in which the transmitter is used.

US 2013/343471 A1 describes a signal transmission circuit including a driver circuit that includes complementary inverters, each of the complementary inverters including a plurality of transistor switches, each of the plurality of transistor switches including a pair of transistors, one of the pair of transistors operating in a saturation region and another of the pair of transistors operating in a triode region to cause a certain impedance, and that drives each of the plurality of transistor switches in accordance with complementary signals so as to output complementary voltages to a transmission line; and first voltage sources that supply operating voltages to the driver circuit so as to adjust amplitudes of the complementary voltages output from the driver circuit to the transmission line.

US 2013/163126 describes a differential line driver with N-paralleled slices for driving an impedance-matched transmission line. Each driver slice is a modified H-bridge driver using low-voltage, high-speed transistors. By using a voltage-dropping first resistor in each slice, a high-voltage power supply that would normally damage the transistors can be used to power the driver and produce a differential output signal with peak-to-peak amplitudes that otherwise might not be possible. Each transistor in each driver slice has a resistor disposed between the transistor and the respective output node of the driver to enhance ESD protection of the transistors and, in combination with the first resistor, to impedance match the driver to the transmission line.

### SUMMARY

Techniques for impedance and swing control for a voltage-mode driver are described. According to a first aspect of the disclosure, a driver circuit is as defined in claim 1.

In an example, a driver circuit includes a plurality of output circuits coupled in parallel between a differential input and a differential output and having a first common node and a second common node. Each of the plurality of output circuits includes a series combination of a pair of enable circuits, a pair of inverters, and a pair of resistors, coupled between the differential input and the differential output; a first transistor coupled between the first common node and first source terminals of the pair of inverters; and a second transistor coupled between the second common node and second source terminals of the pair of inverters. The driver circuit further includes first and second replica output circuits coupled in series between the first and second common nodes; and a control circuit coupled to each of: respective gates of the first and second transistors in each of the plurality of output circuits; and the first and second replica output circuits.

According to a second aspect of the disclosure, a method of controlling a driver circuit in a transmitter is as defined in claim 12.

These and other aspects may be understood with reference to the following detailed description.

### BRIEF DESCRIPTION OF THE DRAWINGS

So that the manner in which the above recited features can be understood in detail, a more particular description, briefly summarized above, may be had by reference to example implementations, some of which are illustrated in the appended drawings. It is to be noted, however, that the appended drawings
illustrate only typical example implementations and are therefore not to be considered limiting of its scope.
Fig. 1 is a block diagram depicting an example of a serial communication system.
Fig. 2 is a schematic diagram depicting an output driver according to an example,
Figs. 3A-3B depict a schematic diagram of an output driver according to another example.
Fig. 4 is a flow diagram depicting a method of controlling a driver circuit in a transmitter according to an example.
Fig. 5 is a block diagram depicting an example of a serial communication system.
Fig. 6 is a schematic diagram depicting an output driver according to an example.
Fig. 7 is a schematic diagram depicting a voltage regulator according to an example.
Fig. 8 is a schematic diagram depicting an error amplifier for the voltage regulator of Fig. 7 according to an example.
Fig. 9 is a block diagram depicting an example of a serial communication system.
Fig. 10 is a block diagram depicting a portion of a transmitter according to an example.
Fig. 11 is a schematic diagram depicting an output driver according to an example.
Fig. 12 is a schematic diagram depicting a current compensation circuit of the output driver of Fig. 11.
Fig. 13A is a table illustrating an example portion of a 1T main-cursor signal and its associated 2T odd signals.
Fig. 13B is a table illustrating an example portion of a 1T main-cursor signal and its associated 2T even signals.

To facilitate understanding, identical reference numerals have been used, where possible, to designate identical elements that are common to the figures. It is contemplated that elements of one example may be beneficially incorporated in other examples.

### DETAILED DESCRIPTION

Various features are described hereinafter with reference to the figures. It should be noted that the figures may or may not be drawn to scale and that the elements of similar structures or functions are represented by like reference numerals throughout the figures. It should be noted that the figures are only intended to facilitate the description of the features. They are not intended as an exhaustive description of the claimed invention or as a limitation on the scope of the claimed invention. In addition, an illustrated example need not have all the aspects or advantages shown. An aspect or an advantage described in conjunction with a particular example is not necessarily limited to that example and can be practiced in any other examples even if not so illustrated or if not so explicitly described.

Techniques for impedance and swing control for a voltage-mode driver are described. In an example, a driver circuit includes output circuits between a differential input and a differential output. The output circuits are coupled between first and second common nodes. Each output circuit includes a pair of inverters and a pair of resistors coupled between the differential input and output. First source terminals of the pair of inverters are coupled to the first common node and second source terminals of the pair of inverters are coupled to the second common node. First and second voltage regulators are coupled to the first and second common nodes. A current compensation circuit is coupled between outputs of the first and second voltage regulators. Zero or more of the current compensation circuits can be selectively enabled to draw dummy current from the voltage regulators to improve return loss, as discussed further below. Further, use of dual regulators allows for a fixed common mode in both low- and high-swing modes. These and further aspects are discussed below with respect to the drawings.

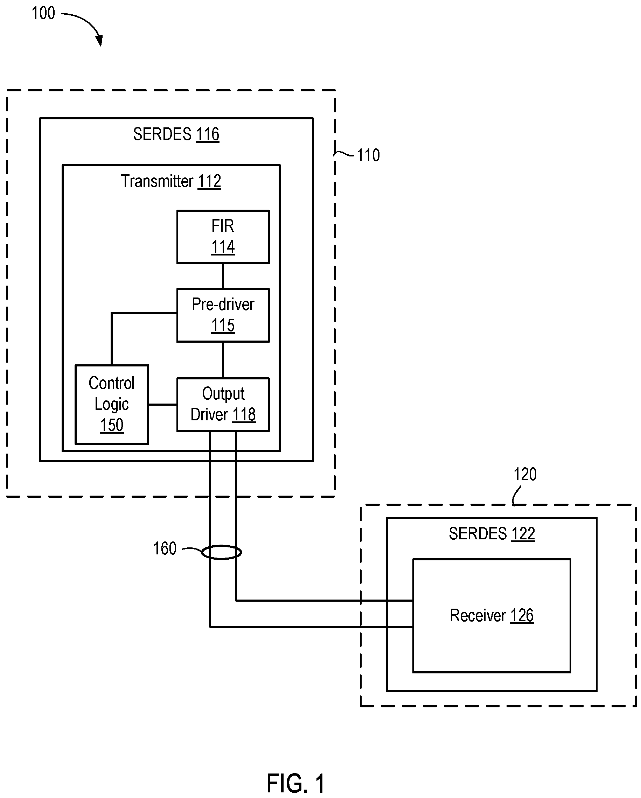

Fig. 1 is a block diagram depicting an example of a serial communication system 100. The serial communication system 100 comprises a transmitter 112 coupled to a receiver 126 over transmission medium 160. The transmitter 112 can be part of a serializer-deserializer (SERDES) 116. The receiver 126 can be part of a SERDES 122. The transmission medium 160 comprises an electrical path between the transmitter 112 and the receiver 126 and can include printed circuit board (PCB) traces, vias, cables, connectors, decoupling capacitors, and the like. In examples, the transmission medium 160 includes a matched pair of transmission lines each having a characteristic impedance (ZO). The receiver of the SERDES 116, and the transmitter of the SERDES 122, are omitted for clarity. In some examples, the SERDES 116 can be disposed in an integrated circuit (IC) 110, and the SERDES 122 can be disposed in an IC 120.

in general, the transmitter 112 generates a serial data signal from a parallel data path (serialization). The serial data signal has a particular data rate (symbol rate). In some examples, data bytes from the parallel data path can be encoded prior to serialization using, for example, and 8B/10B encoder or the like. The transmitter 112 drives the serial data signal onto the transmission medium 160 using a digital modulation technique, such as binary non-return-to-zero (NRZ) pulse amplitude modulation (PAM). The transmission medium 160 propagates electrical signal(s) representing symbols of the serial data signal (e.g., logic "1" and logic "0") towards the receiver 126.

In the example shown, the transmission medium 160 is a differential channel. Data on the differential channel is represented using two electrical signals ("true" and "complement" signals). A logic "0" is represented by driving the true signal to its lower voltage limit and driving the complement signal to its upper voltage limit. A logic "1" is represented by driving the true signal to its upper voltage limit and driving the complement signal to its lower voltage limit. Thus, the logic value of each transmitted symbol is based on the difference between the true and complement signals, and not based on the level of either signal individually. The peak-to-peak difference between the true signal and the complement signal is the voltage swing (also referred to as signal swing or swing).

The transmitter 112 includes a finite impulse response (FIR) filter 114, a pre-driver 115, an output driver 118, and control logic 150. The transmitter 112 is configured to equalize the serial data signal prior to transmission over the transmission medium 160. The FIR 114 can be used to mitigate inter-symbol interference (ISI) caused by the transmission medium 160. The transmission medium 160 degrades the signal quality of the transmitted signal. Channel insertion loss is the frequency-dependent degradation in signal power of the transmitted signal. When signals travel through a transmission line, the high frequency components of the transmitted signal are attenuated more than the low frequency components. In general, channel insertion loss increases as frequency increases. Signal pulse energy in the transmitted signal can be spread from one symbol period to another during propagation on the transmission medium 160. The resulting distortion is known as ISI. In general, ISI becomes worse as the speed of the communication system increases.

The output of the FIR filter 114 is coupled to an input of the pre-driver 115. The output of the FIR filter 114 can include a plurality of signals, including a main-cursor signal, and one or more pre-cursor signals, one or more post-cursor signals, or a plurality of post-cursor and pre-cursor signals. For purposes of clarity by example, the present description assumes the FIR filter 114 outputs one main-cursor signal, one pre-cursor signal, and one post-cursor signal. The pre-driver 115 is configured to couple the output of the FIR filter 114 to the output driver 118. As discussed below, the output driver 118 is segmented and includes a plurality of output circuits coupled in parallel to the transmission medium 160. The pre-driver 115 couples each of the main-cursor, the pre-cursor, and the post-cursor signals to a selected percentage of the output circuits of the output driver 118. The percentages of output circuits driven by the main-cursor, pre-cursor, and post-cursor signals as selected by the pre-driver 115 is controlled by the control logic 150. The control logic 150 also controls aspects of the output driver 118, as discussed further below.

While the SERDES 116 and the SERDES 122 are shown, in other examples, each of the transmitter 112 and/or the receiver 126 can be a standalone circuit not being part of a larger transceiver circuit. In some examples, the transmitter 112 and the receiver 126 can be part of one or more integrated circuits (ICs), such as application specific integrated circuits (ASICs) or programmable ICs, such as field programmable gate arrays (FPGAs).

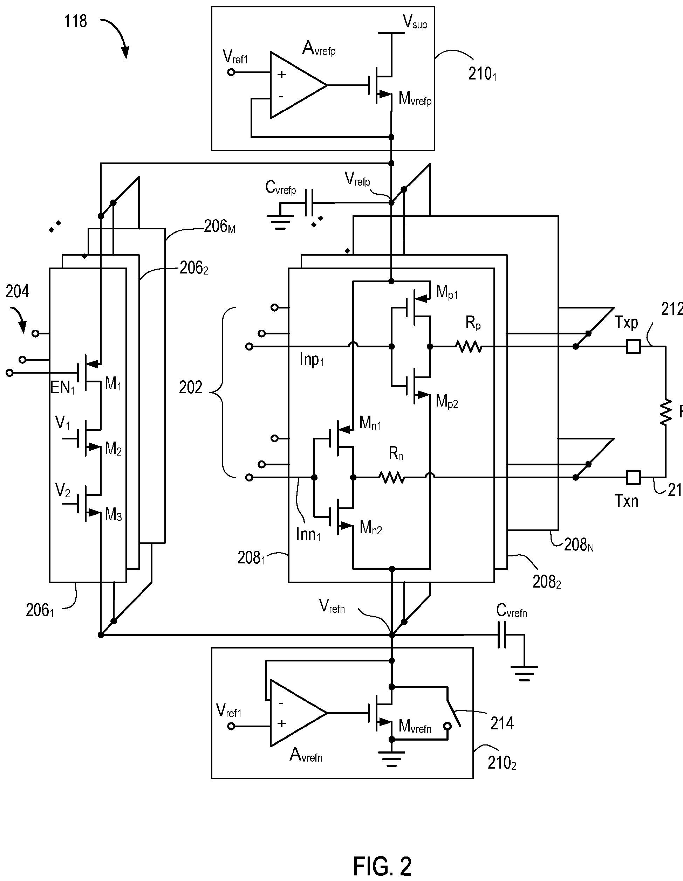

Fig. 2 is a schematic diagram depicting the output driver 118 according to an example. The output driver 118 includes output circuits 208, through 208_{N} (where N is an integer greater than one), voltage regulators 210₁ and 210₂, and current compensation circuits 206₁ through 206_{M} (where M is an integer greater than one). The output circuits 208₁ through 208_{N} are collectively referred to as output circuits 208; the voltage regulators 210₁ and 210₂ are collectively referred to as voltage regulators 210; and the current compensation circuits 206₁ through 206_{M} are collectively referred to as current compensation circuits 206.

The output circuits 208 are coupled in parallel between a differential input 202 and a differential output (Txp, Txn). The differential input 202 includes N differential signals output by the pre-driver 115. Each differential signal includes a true signal, Inp, and a complement signal, Inn. Thus, the differential input 202 includes signals Inp₁ through Inp_{N} and signals Inn₁ through Inn_{N}.

The output circuits 208 are coupled to common nodes V_{refp} and V_{refn}. Each of the output circuits 208 includes transistors Mₚ₁, Mₚ₂, Mₙ₁, and Mₙ₂. Each of the output circuits 208 also includes resistors Rₚ and Rₙ. The transistors Mₚ₁ and Mₙ₁ comprise p-channel field effect transistors (FETs), such as P-type metaloxide semiconductor FETs (MOSFETs) (also referred to as PMOS transistors). The transistors Mₚ₂ and Mₙ₂ comprise n-channel FETs, such as N-type MOSFETs (also referred to as NMOS transistors). For purposes of clarity, only the output circuit 208₁ is shown in detail. However, each of the output circuits 208₂ through 208_{N} are configured identically with the output circuit 208₁.

Sources of the transistors Mₚ₁ and Mₙ₁ are coupled to the common node V_{refp}. Drains of the transistors Mₚ₁ and Mₙ₁ are coupled to drains of the transistors Mₚ₂ and Mₙ₂, respectively. Sources of the transistors Mₚ₂ and Mₙ₂ are coupled to the common node V_{refn}. Gates of the transistors Mₚ₁ and Mₚ₂ are coupled together and are coupled to receive a signal Inp of one of the input differential signals. Gates of the transistors Mₙ₁ and Mₙ₂ are coupled together and are coupled to receive a signal Inn of one of the input differential signals. A first terminal of the resistor Rₚ is coupled to the drains of the transistors Mₚ₁ and Mₚ₂, and a second terminal of the resistor Rₚ is coupled to the node Txp of the differential output. A first terminal of the resistor Rₙ is coupled to the drains of the transistors Mₙ₁ and Mₙ₂, and a second terminal of the resistor Rₙ is coupled to the node Txn of the differential output. The transistors Mₚ₁ and Mₚ₂ form a first inverter (Mp), and the transistors Mₙ₁ and Mₙ₂ form a second inverter (Mn). A series combination of the pair of inverters (Mp, Mn) and the pair of resistors Rₚ and Rₙ is coupled between the differential input 202 and the differential output (Txp, Txn). The source terminals of the inverters are coupled between the nodes V_{refp} and V_{refn}.

The voltage regulator 210₁ includes an operational amplifier A_{vrefp} and a transistor M_{vrefp}. The transistor M_{vrefp} is an n-channel FET, such as an N-type MOSFET. A non-inverting input terminal of the operational amplifier A_{vrefp} is coupled to a first reference voltage source (V_{ref1}). An inverting input of the operational amplifier A_{vrefp} is coupled to the node V_{refp}. A drain of the transistor M_{vrefp} is coupled to a supply voltage source (Vₛᵤₚ). A source of the transistor M_{vrefp} is coupled to the node V_{refp}. A gate of the transistor M_{vrefp} is coupled to an output of the operational amplifier A_{vrefp}.

The voltage regulator 210₂ includes an operational amplifier A_{vrefn} and a transistor M_{vrefn}. The transistor M_{vrefn} is an n-channel FET, such as an N-type MOSFET. A non-inverting input terminal of the operational amplifier A_{vrefn} is coupled to a second reference voltage source (V_{ref2}). An inverting input of the operational amplifier A_{vrefn} is coupled to the node V_{refn}. A source of the transistor M_{vrefn} is coupled to a ground voltage source. A drain of the transistor MV_{refn} is coupled to the node V_{refn}. A gate of the transistor MV_{refn} is coupled to an output of the operational amplifier A_{vrefn}.

The current compensation circuits 206 are coupled in parallel between the nodes V_{refp} and V_{refn}. Each of the current compensation circuits 206 includes transistors M₁, M₂, and M₃. The transistor M₁ is a p-channel FET, such as a P-type MOSFET. The transistors M₂ and M₃ are n-channel FETs, such as an N-type MOSFET. For purposes of clarity, only the current compensation circuit 206₁ is shown in detail. However, each of the current compensation circuits 206₂ through 206_{M} are configured identically with the current compensation circuit 206₁.

A source of the transistor M₁ is coupled to the node V_{refp}. A drain of the transistor M₁ is coupled to a drain of the transistor M₂. A source of the transistor M₂ is coupled to a drain of the transistor M₃, A source of the transistor M₃ is coupled to the node V_{refn}. A gate of the transistor M₂ in each of the current compensation circuits 206 is coupled to a bias voltage source V₁. A gate of the transistor M₃ in each of the current compensation circuits 206 is coupled to a bias voltage source V₂. A gate of the transistor M₁ is coupled to receive an enable signal of an enable input 204. The enable input 204 includes M enable signals EN₁ through EN_{M} coupled to the M current compensation circuits 206, respectively.

The output driver 118 further includes capacitors C_{vrefp} and C_{vrefn}. The capacitor C_{vrefp} is coupled between the node V_{refp} and electrical ground. The capacitor C_{vrefn} is coupled between the node V_{refn} and electrical ground.

The differential output (Txp, Txn) is coupled to a pair of transmission lines 212ₚ and 212ₙ (collectively transmission lines 212). The transmission lines 212 drive a load resistance R_{L}. The transmission lines 212 and the load resistance R_{L} are not part of the output driver 118. Rather, the transmission lines 212 are part of the transmission medium 160 and the load resistance R_{L} is part of the receiver 126.

In operation, each output circuit 208 includes a pair of inverters driven by complementary input (a differential signal of the differential input 202). Each differential signal of the differential input 202 can be one of a main-cursor signal, a post-cursor signal, or a pre-cursor signal. As discussed above, the pre-driver 115 controls the number of output circuits 208 receiving each of the main-cursor, post-cursor, and pre-cursor signals. For example, the output circuits can receive all main-cursor signals, some main-cursor signals and some pre-cursor signals, some main-cursor signals and some post-cursor signals, or some main-cursor signals, some post-cursor signals, and some pre-cursor signals. Mixing post/pre-cursor signals with the main-cursor signals is used to implement emphasis and de-emphasis equalization in the transmitter 112.

The voltage regulators 210 set the swing of the output driver 118. The differential peak-to-peak swing is V_{refp} - V_{refn}. In an example, the voltage regulator 210₂ can include a switch 214 configured to short the drain of the transistor M_{vrefn} to electrical ground. This allows the voltage regulator 210₂ to be disabled in one mode (high-swing mode) and enabled in another mode (low swing mode). Zero or more of the current compensation circuits 206 are selectively enabled using the enable input 204 to draw dummy current from the voltage regulator 210 to improve return loss, as discussed further below. A control signal for the switch 214, and the enable input to the current compensation circuits 206, can be generated by the control logic 150.

With the dual regulators 210₁ and 210₂ in the output driver 118, the swing and common-mode can be set independently. For example, the common-mode can be fixed at 0.45 V. Table 1 below illustrates characteristics of the high-swing mode and the low-swing mode for both dual regulators and a single regulator.

**Table 1**

| Regulator Mode | Swing | V_{refp} | V_{refn} | Common-mode |
|---|---|---|---|---|
| Dual | 0.6 V | 0.75 V | 0.15 V | 0.45 V |
| Dual | 0.9 V | 0.9 V | 0 V | 0.45 V |
| Single | 0.6 V | 0.6 V | 0 V | 0.3 V |
| Single | 0.9 V | 0.9 V | 0 V | 0.45 V |

As shown in Table 1, when both regulators 210₁ and 210₂ are enabled, the common-mode is the target 0.45 V for the low-swing mode (e.g., 0.6 V). If only the regulator 210₁ is enabled, the common mode is lower than the target 0.45 V (e.g., 0.3 V) for the low-swing mode. Use of dual regulators allows for a fixed common mode in both low- and high-swing modes. The values in Table 1 are exemplary and the output driver 118 can be configured with other common-mode voltages, other high-swing voltages, and other-low-swing voltages.

In the output driver 118, equalization can be implemented by driving a different number of the output circuits 208 with different main/pre/post cursor signals. With the dual-regulator approach, the swing is changed by adjusting the regulator voltage. Thus, equalization control is independent of the swing control. This allows for high FIR resolution even in low-swing mode.

For a voltage-mode driver, the current drawn by the output circuits 208 can be calculated using the following relationship: ld = (differential swing) / (external differential resistance + internal differential resistance). In an example, each transmission line 212ₚ and 212ₙ has a characteristic impedance Z0 of 50 ohms (external differential resistance = 100 ohms). Ideally, the output driver 118 provides a matching impedance of 50 ohms for each transmission line 212 (e.g., internal differential resistance = 100 ohms). If the desired swing is 0.9 V, then the current drawn by the output circuits 208 is approximately 4.5 mA. The actual current consumption may be higher to account for transient switching crowbar current.

For the above equation, it is noted that the current drawn by the output circuits 208 changes with the output swing. For lower swing, less current is drawn by the output circuits 208 from the voltage regulator 210₁. The output impedance of the voltage regulator 210₁ increases as less current is drawn from the voltage regulator 210₁. Notably, the output impedance of the voltage regulator 210₁ is the output resistance of the transistor M_{vrefp} (gm) divided by (1 + loop gain). When the voltage regulator 210₁ supplies low current, the operational amplifier A_{vrefp} provides less loop gain, thereby increasing the output impedance of the voltage regulator 210₁. The output circuits 208 see an effective impedance of the capacitor C_{vrefp} in parallel with the output impedance of the voltage regulator 210₁. For mid- to low-frequencies (e.g., 100 MHz), the impedance of the capacitor C_{vrefp} is high and thus the output impedance of the voltage regulator 210₁ is not negligible. Thus, the decreased output impedance of the voltage regulator 210₁ due to low current draw by the output circuits 208 degrades the return loss of the output driver 118.

The current compensation circuits 206 are selectively enabled to mitigate the increase in return loss by drawing a constant dummy current in parallel with the output circuits 208. Thus, at higher swing settings, less or none of the current compensation circuits 206 can be enabled, as sufficient current is drawn from the voltage regulator 210₁. At lower swing settings, more of the current compensation circuits 206 can be enabled, which ensures that sufficient current is drawn from the voltage regulator 210₁ to maintain loop gain and low output impedance.

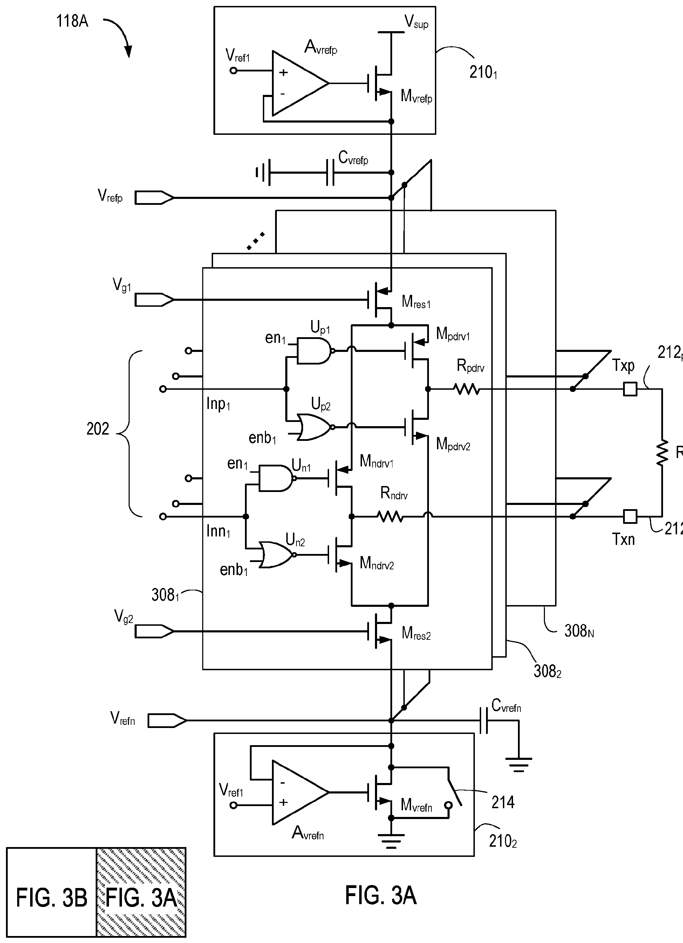

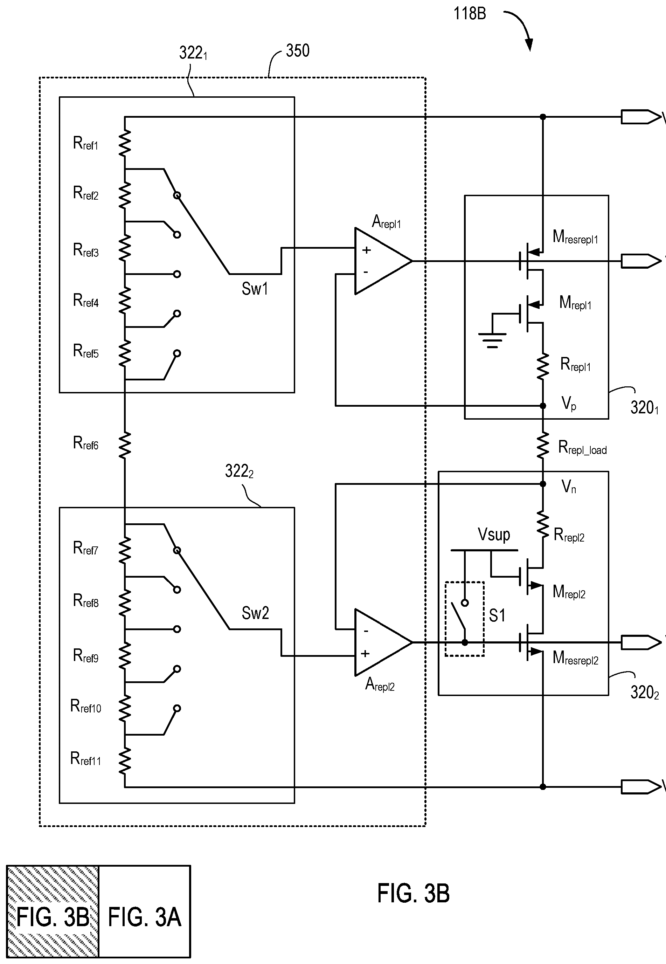

Figs. 3A-3B depict a schematic diagram of the output driver 118 according to another example. Fig. 3A shows a portion 118A of the output driver 118, and Fig. 3B shows a portion 118B of the output driver 118. Elements in Figs. 3A and 3B that are the same or similar to those of Fig. 2 are designated with identical reference numerals and are described above. The output driver 118 includes output circuits 308₁ through 308_{N} (where N is an integer greater than one), the voltage regulators 210, and 210₂, replica circuits 320, and 320₂, and a control circuit 350 comprising operational amplifiers Arepl₁, Aᵣₑₚₗ₂, and resistors R_{ref1} through R_{ref11}. The output circuits 308₁ through 308_{N} are collectively referred to as output circuits 308, and the replica circuits 320₁ and 320₂ are collectively referred to as replica circuits 320. In some examples, the output driver shown in Figs. 3A and 3B can also include the current compensation circuits 206 described above. For purposes of clarity, the current compensation circuits 206 are omitted from Figs. 3A and 3B.

As shown in the portion 118A of the output driver 118 in Fig. 3A, the output circuits 308 are coupled in parallel between the differential input 202 and the differential output (Txp, Txn). The output circuits 308 are coupled to the common nodes V_{refp} and V_{refn}. Each of the output circuits 308 includes transistors M_{pdrv1}, M_{pdrv2}, M_{ndrv1}, M_{ndrv2}, Mᵣₑₛ₁, and Mᵣₑₛ₂. Each of the output circuits 208 also includes resistors R_{pdrv} and R_{ndrv}, and enable circuit Uₚ formed by NAND gate Uₚ₁ and Uₚ₂, and an enable circuit Uₙ formed by Uₙ₁ and Uₙ₂. The transistors M_{pdrv1} and M_{ndrv1} comprise p-channel FETs, such as P-type MOSFETs. The transistors M_{pdrv2} and M_{ndrv2} comprise n-channel FETs, such as N-type MOSFETs. Sources of the transistors M_{pdrv1} and M_{ndrv1} are coupled to a drain of the transistor Mᵣₑₛ₁, Drains of the transistors M_{pdrv1} and M_{ndrv1} are coupled to drains of the transistors M_{pdrv2} and M_{ndrv2}, respectively. Sources of the transistors M_{pdrv2} and M_{ndrv2} are coupled to a drain of the transistor Mᵣₑₛ₂.

Gates of the transistors M_{pdrv1} and M_{pdrv2} are coupled to outputs of the NAND gate Uₚ₁ and the NOR gate Uₚ₂, respectively. In another example, the NAND gate Uₚ₁ and the NOR gate Uₚ₂ are replaced by a single inverter having an output coupled to the gates of the transistors M_{pdrv1} and M_{pdrv2}. First input terminals of the NAND gate Uₚ₁ and the NOR gate Uₚ₂ are coupled together, and are coupled to receive one end of a differential input signal (Inp). Second inputs of the NAND gate Uₚ₁ and the NOR gate Uₚ₂ are coupled to a true enable signal en and a complement enable signal enb. Gates of the transistors M_{ndrv1} and M_{ndrv2} are coupled to outputs of the NAND gate Uₙ₁ and the NOR gate Uₙ₂, respectively. First input terminals of the NAND gate Uₙ₁ and the NOR gate Uₙ₂ are coupled together, and are coupled to receive the other end of the differential input signal (Inn). Second inputs of the NAND gate Uₙ₁ and the NOR gate Uₙ₂ are coupled to the true enable signal en and the complement enable signal enb. The true enable signal en and the complement enable signal enb are signals of a true enable input and a complement enable input, respectively. The true enable input includes N true enable signals en₁ through en_{N} respectively coupled to the N output circuits 308, and the complement enable input includes N complement enable signals enb₁ through enb_{N} respectively coupled to the N output circuits 308.

A source of the transistor Mᵣₑₛ₁ is coupled to the common node V_{refp}. A source of the transistor Mᵣₑₛ₂ is coupled to the common node V_{refn}. A gate of the transistor Mᵣₑₛ₁ is coupled to an output of the operational amplifier Arepl1 (designated node V_{g1}). A gate of the transistor Mᵣₑₛ₂ is coupled to an output of the operational amplifier Aᵣₑₚₗ₂ (designated node V_{g2}).

One terminal of the resistor R_{pdrv} is coupled to the drains of the transistors M_{pdrv1} and M_{pdrv2}, and another terminal of the resistor R_{pdrv} is coupled to the node Txp of the differential output. One terminal of the resistor R_{ndrv} is coupled to the drains of the transistors M_{ndrv1} and M_{ndrv2}, and another terminal of the resistor R_{ndrv} is coupled to the node Txn of the differential output. The transistors M_{pdrv1} and M_{pdrv2} form a first inverter (M_{pdrv}), and the transistors M_{ndrv1} and M_{ndrv2} form a second inverter (M_{ndrv}). A series combination of the enable circuits (Uₚ, Uₙ), the pair of inverters (M_{pdrv}, M_{ndrv}) and the pair of resistors R_{pdrv} and R_{ndrv} is coupled between the differential input 202 and the differential output (Txp, Txn). The source terminals of the inverters (M_{pdrv}, M_{ndrv}) are coupled between the nodes V_{refp} and V_{refn}.

As shown in the portion 118B of the output driver 118, the replica output circuit 3201 includes transistors Mᵣₑₛᵣₑₚₗ₁ and Mᵣₑₚₗ₁ and a resistor Rᵣₑₚₗ₁. The transistors Mᵣₑₛᵣₑₚₗ₁ and Mᵣₑₚₗ₁ are each a p-channel FET, such as a P-type MOSFET. A source of the transistor Mᵣₑₛᵣₑₚₗ₁ is coupled to the common node V_{refp}. A drain of the transistor Mᵣₑₛᵣₑₚₗ₁ is coupled to a source of the transistor Mᵣₑₚₗ₁. A drain of the transistor Mᵣₑₚₗ₁ is coupled to one terminal of the resistor Rᵣₑₚₗ₁. Another terminal of the resistor Rᵣₑₚₗ₁ is coupled to one terminal of a resistor R_{repl_load} at a node Vₚ. A gate of the transistor Mᵣₑₛᵣₑₚₗ₁ is coupled to the output of the operational amplifier Aᵣₑₚₗ₁. A gate of the transistor Mᵣₑₚ₁ is coupled to a ground source.

The replica output circuit 320₂ includes transistors Mᵣₑₛᵣₑₚₗ₂ and Mrepl2 and a resistor Rᵣₑₚₗ₂. The transistors Mᵣₑₛᵣₑₚₗ₂ and Mᵣₑₚₗ₂ are each an n-channel FET, such as a N-type MOSFET. A source of the transistor Mᵣₑₛᵣₑₚₗ₂ is coupled to the common node V_{refn}. A drain of the transistor Mᵣₑₛᵣₑₚₗ₂ is coupled to a source of the transistor Mrepl2. A drain of the transistor Mrepl2 is coupled to one terminal of the resistor Rᵣₑₚₗ₂. Another terminal of the resistor Rᵣₑₚₗ₂ is coupled to a second terminal of a resistor R_{repl_load} at a node Vn. A gate of the transistor Mᵣₑₛᵣₑₚₗ₂ is coupled to the output of the operational amplifier Aᵣₑₚₗ₂. A gate of the transistor Mᵣₑₚ₂ is coupled to a supply source (Vₛᵤₚ). The replica output circuit 320₂ also includes a startup circuit S1. The startup circuit S1 comprises a switch coupled between the output of the operational amplifier Aᵣₑₚₗ₂ and the supply source Vₛᵤₚ.

An inverting input of the operational amplifier Aᵣₑₚₗ₁ is coupled between the resistor Rᵣₑₚₗ₁ and the resistor R_{repl_load}. A non-inverting input of the operational amplifier Aᵣₑₚₗ₁ is coupled to a switched resistor network 322₁. The switched resistor network 322₁ comprises the resistors R_{ref1} through Rref5 and a switch Sw1. The resistors R_{ref1} through R_{ref5} are coupled in series between the node V_{refp} and the resistor R_{ref6}. The switched resistor network 322₁ includes a plurality of taps (e.g., 5 taps in the example). The switch Sw1 is controllable to couple the non-inverting input of the operational amplifier Arepl1 to one of the taps.

An inverting input of the operational amplifier Aᵣₑₚₗ₂ is coupled between the resistor Rᵣₑₚₗ₂ and the resistor R_{repl_load}. A non-inverting input of the operational amplifier Aᵣₑₚₗ₂ is coupled to a switched resistor network 322₂. The switched resistor network 322₂ comprises the resistors R_{ref7} through R_{ref11} and a switch Sw2. The resistors R_{ref7} through R_{ref11} are coupled in series between the node V_{refn} and the resistor R_{ref6}. The switched resistor network 322₂ includes a plurality of taps (e.g., 5 taps in the example). The switch Sw2 is controllable to couple the non-inverting input of the operational amplifier Aᵣₑₚₗ₂ to one of the taps.

One example technique for impedance control is to provide a pair of programmable resistors stacked in series with all output slices of the driver array. The intent is to adjust the programmable resistors to compensate for variations in the output slices. However, as the programmable resistors are shared by all of the output slices, the differential impedance will deviate from the desired 100 ohms when some output slices are driven in the opposite direction. Another example technique for impedance control is to configure the output slices of the driver array to be selectively enabled/disabled However, such a technique alone does not compensate for the difference in process variations of PMOS and NMOS transistors, e.g., when PMOS is at fast corner while NMOS is at slow corner and vice versa.

in an example, the output driver 118 provides for impedance control that addresses these problems. Turning on/off output circuits 308 is used to only compensate for on-chip resistor variations. To compensate for NMOS/PMOS variations, each output circuit 308 includes a pair of stacked programmable resistors (described below). The impedance of the stacked programmable resistors is controlled by two impedance control loops.

in operation, the output circuits 308 can be selectively enabled on or off through the enable input. The enable input can be provided by the control logic 150. If enabled, an output circuit 308 contributes to the differential output (Txp, Txn). If disabled, the output circuit 308 does not contribute to the differential output (Txp, Txn) (high impedance state). Turning output circuits 308 on/off provides for coarse impedance control to compensate for variation in the on-chip resistors R_{pdrv} and R_{ndrv}. The transistors Mᵣₑₛ₁ and Mᵣₑₛ₂ are driven to operate in the triode region to provide programmable resistors controllable through V_{g}1 and V_{g2}, respectively. The transistors Mᵣₑₛ₁ and Mᵣₑₛ₂ are controlled to compensate for variation in the transistors M_{pdrv1}, M_{pdrv2}, M_{ndrv1}, and M_{ndrv2}. The resistance provided by the transistors Mᵣₑₛ₁ and Mᵣₑₛ₂ is controlled by adjusting their respective gate-to-source voltages using feedback control loops. A feedback control loop that controls the transistor Mᵣₑₛ₁ comprises the replica 320, and the operational amplifier Aᵣₑₚₗ₁. A feedback control loop that controls the transistor Mᵣₑₛ₂ comprises the replica 320₂ and the operational amplifier Aᵣₑₚₗ₂.

The operational amplifier Aᵣₑₚₗ₁ adjusts the gate-to-source voltage of the transistor Mᵣₑₛᵣₑₚₗ₁ such that its impedance is set to a desired value. Notably, the transistor Mᵣₑₛᵣₑₚₗ₁ is fabricated to be a replica of the transistor Mᵣₑₛ₁. The transistor Mᵣₑₚₗ₁ is fabricated to be a replica of a p-channel FET in the output circuits 308 (e.g., the characteristics for each of M_{pdrv1}, M_{pdrv2}, and Mᵣₑₚₗ₁ are the same or substantially similar). The resistor R_{repl_load} is fabricated to be a replica of an on-chip resistor in the output circuits 308 (e.g., the characteristics for each of R_{pdrv}, R_{ndrv}, and R_{repl_load} are the same or substantially similar). Each output circuit 308 (if enabled) includes an internal impedance in series with one of the transmission lines 212 formed by a series combination of Mᵣₑₛ₁, one p-channel FET (i.e., M_{pdrv1} or M_{ndrv1}), and one resistor (R_{pdrv} or R_{ndrv}). The replica 3201 replicates this internal impedance. The desired voltage at node Vₚ is selected at the non-inverting input of the operational amplifier Arepl1 and the operational amplifier Arepl1 drives the node Vₚ to that voltage by controlling the impedance of the transistor Mᵣₑₛᵣₑₚₗ₁. The operational amplifier Arepl1 provides the same control voltage to the gate of the transistor Mᵣₑₛ₁ in each output circuit 308.

The operational amplifier Aᵣₑₚₗ₂ adjusts the gate-to-source voltage of the transistor Mᵣₑₛᵣₑₚₗ₂ such that its impedance is set to a desired value. The transistor Mᵣₑₛᵣₑₚₗ₂ is fabricated to be a replica of the transistor Mᵣₑₛ₂. The transistor Mrepl2 is fabricated to be a replica of a n-channel FET in the output circuits 308 (e.g., the characteristics for each of M_{ndrv1}, M_{ndrv2}, and Mrepl2 are the same or substantially similar). The resistor Rᵣₑₚₗ₂ is fabricated to be a replica of an on-chip resistor in the output circuits 308 (e.g., the characteristics for each of R_{pdrv}, R_{ndrv}, and Rᵣₑₚₗ₂ are the same or substantially similar). Each output circuit 308 (if enabled) includes an internal impedance in series with one of the transmission lines 212 formed by a series combination of Mᵣₑₛ₂, one n-channel FET (i.e., M_{pdrv1} or M_{ndrv1}), and one resistor (R_{pdrv} or R_{ndrv}). The replica 320₂ replicates this internal impedance. The desired voltage at node Vn is selected at the non-inverting input of the operational amplifier Aᵣₑₚₗ₂ and the operational amplifier Aᵣₑₚₗ₂ drives the node Vₙ to that voltage by controlling the impedance of the transistor Mᵣₑₛᵣₑₚₗ₂. The operational amplifier Aᵣₑₚₗ₂ provides the same control voltage to the gate of the transistor Mᵣₑₛ₂ in each output circuit 308.

By including transistors Mᵣₑₛ₁ and Mᵣₑₛ₂ in each output circuit 308, the differential output impedance of the output driver 118 can be maintained to match the transmission medium 160 even when the main and pre/post cursor signals switch in the opposite direction. Further, by provide two feedback control loops for separately controlling the resistance provided by the transistors Mᵣₑₛ₁ and Mᵣₑₛ₂, the output driver 118 can compensate for different NMOS and PMOS process variations.

As shown in Fig. 3B, the two feedback control loops are coupled together through the resistor R_{repl_load} so that the current through the two loops can be reused. To ensure both loops start up properly, the startup circuit S1 can be incorporated into the replica circuit 320₂. The startup circuit S1 can disable one loop initially so that the other loop starts up properly. Alternatively, rather than the startup circuit S1, a common-mode buffer can be used to decouple the two feedback control loops by driving the midpoint of the replica load to a common-mode voltage.

To illustrate the impedance control in more detail, consider an example where the output driver 118 includes N=75 to 85 output circuits 308. Typically, an on-chip resistor can change by ±10% due to process variations. As discussed above, variation in the on-chip resistors R_{pdrv} and R_{ndrv} is compensated for by adjusting the number of enabled output circuits 308 (e.g., between 75 and 85 as shown in the example of Table 2).

**Table 2**

| | 80 Slices | Each Slice | Each slice with resistor +10% | +10% resistor with 85 slices | Each slice with resistor - 10% | -10% resistor with 75 slices |
|---|---|---|---|---|---|---|
| Transistor resistance | 20 ohms | 1600 ohms | 1600 ohms | 18.8 ohms | 1600 ohms | 21.3 ohms |
| On-chip resistance | 30 ohms | 2400 ohms | 2640 ohms | 31.1 ohms | 2160 ohms | 28.8 ohms |
| Total resistance | 50 ohms | 4000 ohms | 4240 ohms | 49.9 ohms | 3760 ohms | 50.2 ohms |

As shown in Table 2, the total output impedance can be maintained at approximately 50 ohms for a given differential output (assuming a 50-ohm characteristic impedance of the transmission line) despite a ±10% variation in on-chip resistance by enabling more or less of the output circuits 308. To calibrate the number of output circuits 308 to be turned on/off, the resistance of the on-chip resistors R_{pdrv} and R_{ndrv} can be sensed with a constant current source (not shown). The control logic 150 can read the output of the sensing operation and then enable/disable the output circuits 308 based on values in a lookup table.

One difference between the replica output circuits 320 and the output circuits 308 is that the load of the replica circuits 320, R_{repl_load}, is implemented with an on-chip resistor, while the actual load for the transmitter, R_{Load}, is a constant termination at the receiver. To avoid using an external resistor or trimming the on-chip resistor R_{repl_load}, the reference voltages used in the feedback control loops can be adjusted to compensate for variation in the on-chip replica resistor R_{repl_load}. This is achieved by selecting a desired voltage at the non-inverting inputs to the operational amplifiers Aᵣₑₚₗ₁ and Aᵣₑₚₗ₂. Note that although each switched resistor network 322 is shown has having five taps for providing five reference voltages, the switched resistor networks 322 can have more or less than five taps.

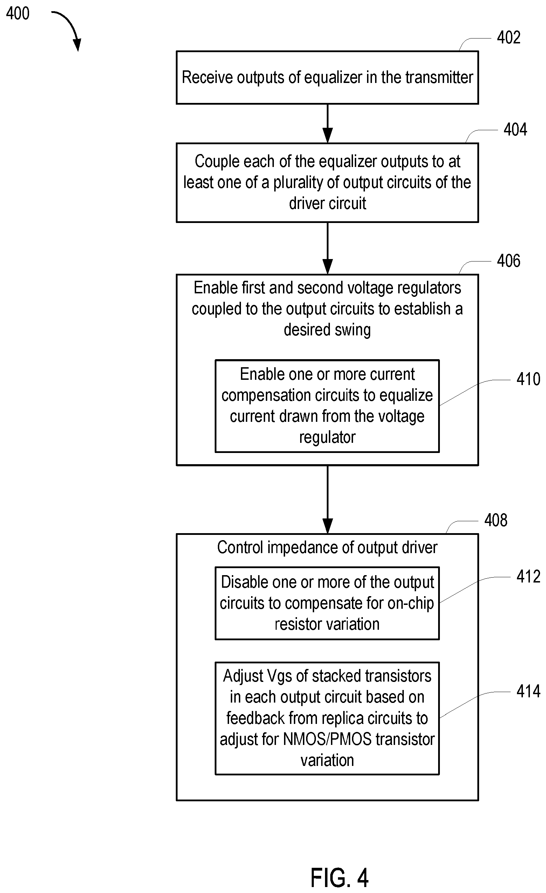

Fig. 4 is a flow diagram depicting a method 400 of controlling a driver circuit in a transmitter according to an example. The method 400 can be performed to control the output driver 118 of the transmitter 112. The method 400 begins at step 402, where the pre-driver 115 receives the outputs of an equalizer in the transmitter 112 (e.g., FIR filter 114). At step 404, the pre-driver 115 couples each equalizer output to at least one of a plurality of output circuits in the output driver 118 (e.g., output circuits 208 or 308). Step 404 implements equalizer control independently from swing control and impedance control. The main-, pre-, and post-cursor signals can be coupled to any number of output circuits in the output driver 118 to achieve the desired emphasis or de-emphasis.

At step 406, the control logic 150 enables first and second voltage regulators 210 coupled to the output circuits in the output driver 118 to establish a desired swing. The voltage output from the dual voltage regulators 210 can be set to generate a desired peak-to-peak voltage swing at the output of the output driver 118. In some cases, at step 410, the control logic 150 can optionally enable one or more current compensation circuits 206 to equalize current drawn from the current-supplying voltage regular (e.g., the voltage regulator 210₁). Step 406 implements output swing control independent of equalizer control and impedance control.

At step 408, the impedance of the output driver is controlled. For example, at step 412, the control logic 150 disables one or more of the output circuits in the output driver 118 to compensate for on-chip resistor variation. This provides for a coarse impedance control. At step 414, feedback control loops in the output driver adjust the gate-to-source voltage of stacked transistors Mᵣₑₛ₁ and Mᵣₑₛ₂ in each output circuit based on feedback from replica circuits 320 to adjust for NMOS/PMOS transistor variation and provide for fine impedance control. As discussed above, the feedback control loops can independently adjust the impedance of the stacked transistors Mᵣₑₛ₁ and Mᵣₑₛ₂ to independently compensate for NMOS and PMOS variations.

### FAST TRANSIENT LOW DROP-OUT VOLTAGE REGULATOR FOR A VOLTAGE-MODE DRIVER

In serial communication systems, a large percentage of the total power is consumed in the transmitter, which must provide for adequate signal swing on a low-impedance channel while maintaining an appropriate source termination. In addition, the transmitter often includes equalization to compensate for frequency-dependent loss in the channel. The driver circuit in the transmitter often consumes the majority of the power of the transmitter. Driver circuits can be implemented as current-mode drivers or voltage-mode drivers. Voltage-mode drivers are known to consume far less power in comparison to current-mode drivers. For example, a voltage-mode driver can consume four times less DC power than a current-mode driver to provide the same output swing.

A voltage-mode driver for a transmitter requires swing and impedance control such that the swing and common-mode/differential-mode return loss are within specifications. One technique for output signal swing control in a driver circuit is to use a single voltage regulator to generate a reference voltage that sets the voltage swing. However, with a single regulator, the common-mode will shift as the output swing of the driver circuit changes. Such a shift in the common-mode can cause the return loss to exceed specifications. Further, conventional low drop-out (LDO) voltage regulators suffer from large ripple, which results in large jitter. Deterministic jitter is an important specification of transmitter driver. A voltage regulator in the transmitter driver should suppress supply ripple as much as possible to have low jitter.

Techniques for providing a fast transient low drop-out (LDO) voltage regulator for a voltage-mode driver are described. In an example, a voltage regulator includes an output transistor that includes a source coupled to a first voltage supply node and a drain coupled to an output node. The voltage regulator further includes a first transistor that includes a source coupled to the output node, and a second transistor that includes a source coupled to a gate of the output transistor and a drain coupled to a second voltage supply node. The voltage regulator further includes a resistor coupled between the second voltage supply node and a first node that includes the drain of the first transistor and a gate of the second transistor. The voltage regulator further includes an error amplifier that includes a first input coupled to a reference voltage node, a second input coupled to the output node, and an output coupled to a gate of the first transistor.

In another example, a driver circuit includes a voltage-mode output driver and a voltage regulator coupled to the voltage-mode output driver. The voltage regulator provides an output voltage to the voltage-mode output driver. The voltage regulator includes an output transistor that includes a source coupled to a first voltage supply node and a drain coupled to an output node, which supplies the output voltage. The voltage regulator further includes a first transistor that includes a source coupled to the output node, and a second transistor that includes a source coupled to a gate of the output transistor and a drain coupled to a second voltage supply node. The voltage regulator further includes a resistor coupled between the second voltage supply node and a first node that includes the drain of the first transistor and a gate of the second transistor. The voltage regulator further includes an error amplifier that includes a first input coupled to a reference voltage node, a second input coupled to the output node, and an output coupled to a gate of the first transistor.

In another example, a voltage regulator includes an output transistor that includes a source coupled to a first voltage supply node and a drain coupled to an output node that supplies a regulated output voltage. A DC regulation loop includes a first source follower configured to control the regulated output voltage and an error amplifier configured to control the first source follower. A fast transient loop that includes a second source follower, a resistor, and the first source follower, the second source follower configured to control the output transistor. A voltage between the resistor and the first source follower controls the second source follower.

Techniques for providing a fast transient low drop-out (LDO) voltage regulator for a voltage-mode driver are described. In an example, a voltage regulator includes an output transistor having a source coupled to a first voltage supply node and a drain coupled to an output node. A first transistor includes a source coupled to the output node. A second transistor includes a source coupled to a gate of the output transistor and a drain coupled to a second voltage supply node. A resistor is coupled between the second voltage supply node and a first node that includes the drain of the first transistor and a gate of the second transistor. An error amplifier includes a first input coupled ot a reference voltage node, a second input coupled to the output node, and an output coupled to a gate of the first transistor.

The voltage regulator regulates output voltage by controlling the voltage at the output node using a DC regulation loop and a fast transient loop. The DC regulation loop includes a source follower, formed by the first transistor and the output transistor, and the error amplifier. The fast transient loop includes another source follower, formed by the second transistor and a current source, which controls the gate voltage of the output transistor. The second transistor acts as a level-shifter and creates a low impedance pole at the gate of the output transistor. The dominant pole is at the output node and two non-dominant poles are in the gigahertz (GHz) range. This allows the voltage regulator to achieve high bandwidth. This significantly mitigates output ripple at the output node. Rather than using two separate loops, the DC regulation loop and the fast transient loop are coupled in the voltage regulator (through the first source follower). These and further aspects are described below with respect to the drawings.

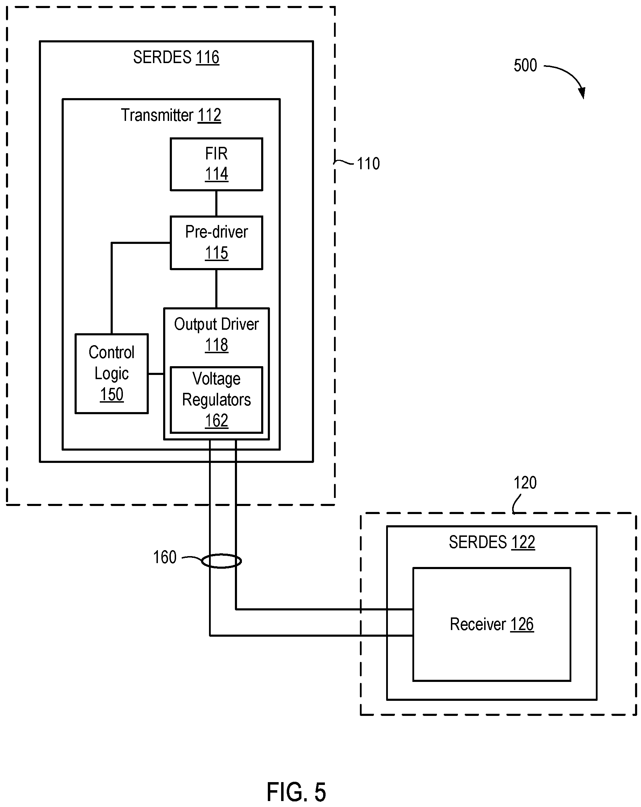

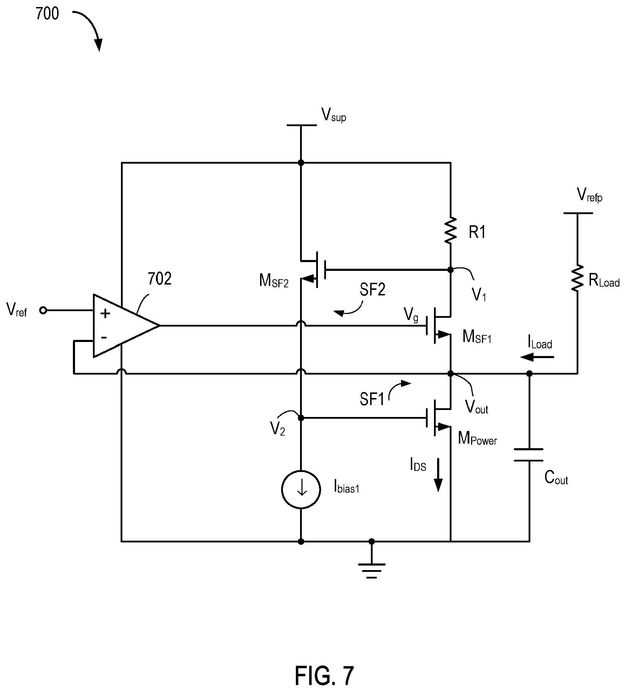

Fig. 5 is a block diagram depicting an example of a serial communication system 500. The serial communication system 500 comprises the transmitter 112 coupled to the receiver 126 over the transmission medium 160, as shown in Fig. 1 and described above. The output driver 118 couples a differential signal to the transmission medium 160. In the present example, the output driver 118 includes a pair of voltage regulators 162 that supply upper and lower voltages to circuits of the output driver 118. An example voltage regulator is shown in Fig. 7 and described below.

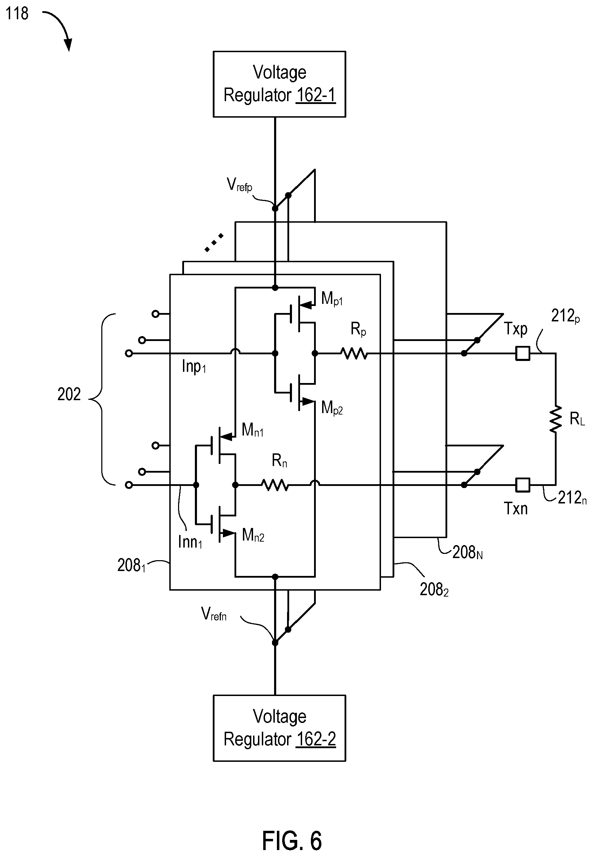

Fig. 6 is a schematic diagram depicting the output driver 118 according to an example. Elements of Fig. 6 that are the same or similar to those of Fig. 2 are designated with identical reference numerals. The output driver 118 includes the output circuits 208₁ through 208_{N} (where N is an integer greater than one) and voltage regulators 162₁ and 162₂. The output circuits 208, through 208_{N} are collectively referred to as output circuits 208. The voltage regulators 162₁ and 162₂ are collectively referred to as voltage regulators 162. The voltage regulator 162₁ is coupled to the common node V_{refp}. The voltage regulator 162₁ controls the voltage at the node V_{refp} and supplies current to the output circuits 208. The voltage regulator 162₂ is coupled to the common node V_{refn}. The voltage regulator 162₂ controls the voltage at the node V_{refn} and sinks current from the output circuits 208.

In operation, each output circuit 208 includes a pair of inverters driven by complementary input (a differential signal of the differential input 202). Each differential signal of the differential input 202 can be one of a main-cursor signal, a post-cursor signal, or a pre-cursor signal. As discussed above, the pre-driver 115 controls the number of output circuits 208 receiving each of the main-cursor, post-cursor, and pre-cursor signals. For example, the output circuits can receive all main-cursor signals, some main-cursor signals and some pre-cursor signals, some main-cursor signals and some post-cursor signals, or some main-cursor signals, some post-cursor signals, and some pre-cursor signals. Mixing post/pre-cursor signals with the main-cursor signals is used to implement emphasis and de-emphasis equalization in the transmitter 112. In the output driver 118, equalization can be implemented by driving a different number of the output circuits 208 with different main/pre/post cursor signals.

For a voltage-mode driver, the current drawn by the output circuits 208 can be calculated using the following relationship: ld = (differential swing) / (external differential resistance + internal differential resistance). In an example, each transmission line 212ₚ and 212ₙ has a characteristic impedance Z0 of 50 ohms (external differential resistance = 100 ohms). Ideally, the output driver 118 provides a matching impedance of 50 ohms for each transmission line 212 (e.g., internal differential resistance = 100 ohms). If the desired swing is 0.75 V, then the current drawn by the output circuits 208 is approximately 3.75 mA. The actual current consumption may be higher to account for transient switching crowbar current. For the above equation, it is noted that the current drawn by the output circuits 208 changes with the output swing. For lower swing, less current is drawn by the output circuits 208 from the voltage regulator 162₁.

The voltage regulators 162 set the swing of the output driver 118. The differential peak-to-peak swing is V_{refp} - V_{refn}. For example, the voltage regulator 162₁ can control the voltage at the common node V_{refp} to be 0.75 V, and the voltage regulator 162₂ can control the voltage at the common node V_{refn} to be 0.15 V. In such an example, the output swing is 0.6 V. Each of the voltage regulators 162 can be a linear voltage regulator, such as a low drop-out (LDO) voltage regulator.

Jitter is an import specification for the output driver 118. As both supply voltages provided to the output driver 118 (e.g., voltages at common nodes V_{refp} and V_{refn}), it is important to have the ripple be as small as possible on each supply voltage to reduce jitter. In order to achieve small ripple, the voltage regulators 162 should be fast transient regulators.

One example LDO voltage regulator applies input voltage to a pass element, which is an n-channel or p-channel FET. The pass element operates in the linear region and drops the input voltage to the desired output voltage. A voltage divider divides the output voltage and an error amplifier senses the divided output voltage. The error amplifier compares the sensed voltage to a reference voltage and drives the gate of the pass element to the appropriate operating point to control the output voltage. Such an LDO regulator has a small bandwidth. The gate node of the pass element is a high-impedance node and is designed as the dominant pole. In order to have sufficient direct current (DC) gain, the impedance at the gate node is high. The dominant pole can be in the range of kilohertz. The non-dominant pole is formed at the output node. For small output ripple, a large decoupling capacitor can be used. Thus, a considerable current is required in order to move the non-dominant pole to higher frequencies and improve the circuit bandwidth. The voltage ripple is proportional to the load current divided by a product of the output capacitance and the bandwidth. The output ripple is significantly high for large changes in the load current. Increasing the output capacitance can reduce ripple, but it also reduces bandwidth. As discussed further below, the voltage regulator shown in Fig. 3 is based on a flipped voltage follower (FVF), which solves this problem with comparatively less current.

Another example LDO voltage regulator uses an FVF architecture. An FVF LDO regulator includes replica biasing. A transistor is biased using a replica circuit including a current mirror and an error amplifier to generate the reference voltage. Such an LDO regulator includes two decoupled loops, one to control the DC output and another to reduce transients. One issue with such an LDO regulator is the DC accuracy. Such an LDO regulator is less immune to process and temperature (PVT) variations. Furthermore, the DC gain of the fast transient loop is low, which results in poor load regulation. Further, the dominant pole in the fast transient loop is formed at the output. Under large load conditions, stability of the system is a concern as the dominant pole moves to higher frequencies (e.g., a few tens of MHz, especially in technology nodes less than 28 nm).

Fig. 7 is a schematic diagram of a voltage regulator 700 according to an example. The voltage regulator 700 is an LDO voltage regulator that can be used as the voltage regulator 162₂ described above. Those skilled in the art will appreciate that the voltage regulator 700 can be used in a myriad of other applications that make use of a low drop-out, linear voltage regulator.

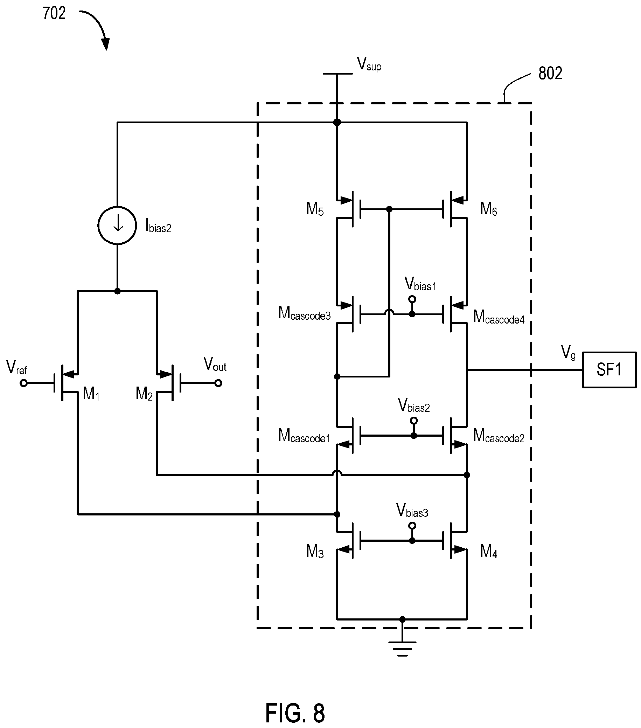

The voltage regulator 700 includes transistors M_{Power}, M_{SF1}, and M_{SF2}. The voltage regulator 700 further includes a resistor R1, a current source I_{bias1}, and an error amplifier 702. The transistors M_{Power}, M_{SF1}, and M_{SF2} are n-channel FETs, such as NMOS transistors. The transistor M_{Power} includes a source coupled to a first voltage node (designated as electrical ground in the example), a base coupled to a node V₂, and a drain coupled to a node Vₒᵤₜ. The transistor M_{SF1} includes a source coupled to the node Vₒᵤₜ, a base coupled to an output of the error amplifier 702, and a drain coupled to a node V₁. The resistor R1 is coupled between a second supply node (designated Vₛᵤₚ in the example) and the node V₁. The transistor M_{SF2} includes a source coupled to the node V₂, a drain coupled to the supply node Vₛᵤₚ, and a base coupled to the node V₁. The current source Ibias is coupled between the node V₂ and the ground node. In the example, the current source I_{bias1} sources current away from the node V₂. The error amplifier 702 includes supply inputs coupled to the node Vₛᵤₚ and the ground node, respectively. The error amplifier 702 further includes a non-inverting input coupled to a node Vref and an inverting input coupled to the node Vₒᵤₜ. An example of the error amplifier 702 is shown in Fig. 8 and described below. A capacitor Cout is coupled between the node Vₒᵤₜ and the ground node.

In operation, the voltage regulator 700 generates a regulated output voltage at the node Vₒᵤₜ from a supply voltage between the node Vₛᵤₚ and the ground node. The regulated output voltage appears across the drain and source of the transistor M_{Power} (e.g., the regulated output voltage is VDS of the transistor M_{Power}). The transistor M_{Power} is also referred to herein as an output transistor. A load R_{Load} can be coupled between a supply voltage (e.g., V_{refp} in Fig. 6) and the node Vₒᵤₜ of the voltage regulator 700. Thus, in an example, the voltage at Vₒᵤₜ is the voltage V_{refn} shown in Fig. 6. The load R_{Load} supplies a DC current, ILoad, which is sinked by the transistor M_{Power}. The transistor M_{Power} conducts a current IDS that includes the load current I_{Load} and a drain-to-source current of the transistor M_{SF1}. The transistor M_{Power} is a power MOSFET or the like sized to accommodate a desired range of load current supplied by the load R_{Load}.

The voltage regulator 700 regulates the output voltage by controlling the voltage at the node Vₒᵤₜ using a DC regulation loop and a fast transient loop. The DC regulation loop includes a first source follower (SF1) that controls the output voltage at the node Vₒᵤₜ and the error amplifier 702, which controls the first source follower. The first source follower is formed by the transistor M_{SF1} and the transistor M_{Power}. The input of the first source follower is a voltage Vg output by the error amplifier 702. An output of the first source follower is the node Vₒᵤₜ. A common input to the first source follower is the node V₁. The DC regulation loop includes the voltage V_{g} applied to the gate of the transistor M_{SF1}, which controls the voltage at the node Vₒᵤₜ, which is fed back to the non-inverting input of the error amplifier 702, which generates the voltage Vg. The error amplifier 702 sets the operating point of the transistor M_{SF1} so that the difference between the voltage Vref and Vₒᵤₜ is substantially zero.

The fast transient loop includes a second source follower (SF2), the resistor R1, and the first source follower (SF1). The second source follower (SF2) includes the transistor M_{SF2} and the current source I_{bias1}. The input of the second source follower is the voltage at the node V₁. An output of the first source follower is the node V₂. A common input to the first source follower is the supply node Vₛᵤₚ. The drain-to-source current of the transistor M_{SF2} is set to the current I_{bias1}. The second source follower controls the transistor M_{Power} by controlling the voltage at the node V₂. The voltage between the resistor R1 and the first source follower (SF1) (the node V₁) controls the second source follower (e.g., the gate voltage of the transistor M_{SF2}). The transistor M_{SF2} acts as a level-shifter and creates a low impedance node at the gate of the transistor M_{Power}. The dominant pole is at the output node Vₒᵤₜ and two non-dominant poles are in the gigahertz (GHz) range. This allows the voltage regulator 700 to achieve high bandwidth. This significantly mitigates output ripple at the node Vₒᵤₜ. Rather than using two separate loops, the DC regulation loop and the fast transient loop are coupled in the voltage regulator 700 (through the first source follower SF1).

Compared to the example LDO regulators described above, the DC accuracy of the voltage regulator 700 is higher. When the load current ILoad increases, the gate voltage of the transistor M_{Power} increases through action of the fast transient loop to sink the additional load current. Conversely, when the load current ILoad decreases, the gate voltage of the transistor M_{Power} decreases through active of the fast transient loop to respond to the change in IDS of the transistor M_{Power}. The voltage Vg at the gate of the transistor M_{SF1} is almost constant, which results in less variations for the DC gain for different load currents and improves load regulation.

In an embodiment, the error amplifier 702 includes a folded cascoded amplifier. An example of the error amplifier 702 is shown in Fig. 8. The output voltage at the node Vₒᵤₜ is directly fed back to the error amplifier 702, rather than a divided output voltage. When the error amplifier 702 is based on a folded cascaded amplifier, the DC gain is high, which provides immunity to PVT variations. Althougth the DC gain of the fast transient loop is low, the high DC gain of the error amplifier 702 compensates, resulting in small variations of the voltage Vg at the gate of the transistor M_{SF1}. Thus, the output voltage at the node Vₒᵤₜ is substantially constant and results in good load regulation.

The resistor R1 is used in the fast transient loop to generate the voltage V₁ rather than use of a current mirror. Since the voltage regulator 700 is not based on replica biasing, using the resistor R1 instead of a current mirror in the fast transient loop has minimal impact on the DC accuracy. The resistor R1 also allows the non-dominant pole to be pushed to higher frequencies without a significant increase in the quiescent current.

Fig. 8 is a schematic diagram depicting the error amplifier 702 according to an example. The error amplifier 702 includes a source-coupled transistor pair (M₁, M₂), a current source I_{bias2}, and a cascode branch circuit 802. The cascode branch circuit 802 (also referred to as an output circuit) includes a base-coupled transistor pair (M₃, M₄), a base-coupled transistor pair (M_{cascode1}, M_{cascode2}), a base-coupled transistor pair (M_{cascode3}, M_{cascode4}), and a base-coupled transistor pair (M5, M₆). The transistor M₁ includes a source coupled to the source of the transistor M₂. The transistor M₁ includes a base coupled to a node Vref and a drain coupled to a drain of the transistor M₃. The transistor M₂ includes a base coupled to the node Vₒᵤₜ and a drain coupled to a drain of the transistor M₄. The current source I_{bias2} is coupled between the supply node Vₛᵤₚ **and the source** node of the source-coupled transistor pair (M₁, M₂). The transistors M₁ and M₂ are p-channel FETs, such as PMOS transistors.

The transistor M₃ includes a source coupled to the ground node, a base coupled to a node V_{bias3}, and a drain coupled to a source of the transistor M_{cascode1}. The transistor M₄ includes a source coupled to the ground node, a base coupled to a node V_{bias3}, and a drain coupled to a source of the transistor M_{cascode2}. The transistor M_{cascode1} includes a base coupled to a node V_{bias2} and a drain coupled to the drain of the transistor M_{cascode3}. The transistor M_{cascode2} includes a base coupled to a node V_{bias2} and a drain coupled to the drain of the transistor M_{cascode4}. The transistor M_{cascode3} includes a base coupled to the node V_{bias1} and a source coupled to a drain of the transistor M₅. The transistor M_{cascode4} includes a base coupled to the node Vbias1 and a source coupled to a drain of the transistor M₆. The transistor M₆ includes a base coupled to a node including the base of the transistor M₆ and another node that includes the drains of the transistors M_{cascode1} and M_{cascode3}. The transistor M₆ includes a source coupled to the supply node Vₛᵤₚ. The transistor M₆ includes a source coupled to the supply node Vₛᵤₚ. The transistors M_{cascode1}, M_{cascode2}, M₃, and M₄ are n-channel FETs, such as NMOS transistors. The transistors M_{cascade3}, M_{cascode4}, M5, and M₆ are p-channel FETs, such as PMOS transistors. A node including the drains of the transistors M_{cascode4} and M_{cascode2} provides the voltage V_{g} coupled to the input of the source follower SF1 shown in Fig. 7 (e.g., the base of the transistors M_{SF1}).

In operation, the transistor pair (M₃, M₄) are load transistors for the source-coupled pair (M₁, M₂). The transistors M₃ and M₄ are gate-biased into saturation by a bias source (not shown) coupled to the node V_{bias}3. Likewise, the cascode pair (M_{cascode1}, M_{cascode2}) and the cascode pair (M_{cascode3}, M_{cascode4}) are gate-biased into saturation by bias sources (not shown) coupled to the nodes V_{bias}2 and V_{bias1}, respectively. The transistors M₅ and M_{cascode3} form a cascode current mirror whose current is reflected to the transistor M₆. The transistors (M₁, M₂) together with the current source I_{bias}2 steer a tail current between the two sides of the source-coupled pair to the load transistors (M₃, M₄) in response to a differential input voltage (Vref - Vₒᵤₜ). When the voltage Vref is equal to the voltage Vₒᵤₜ, an equal current Ibias2/2 flows to each of the load transistors M₃ and M₄.

The load transistors M₃ and M₄ also receive a fixed current produced by the current mirror (M5, M_{cascode3}) and associated transistors M₆, M_{cascode1}, M_{cascode2}, and M_{cascode4}. When the input voltages are equal, the drain-to-source current through load transistors M₃ and M₄ is equal to one half of Ibias2 plus the current of the current mirror and cascoded transistors. An imbalance in the input voltage (Vref - Vₒᵤₜ) causes an imbalance In current between the branches of the cascode branch circuit 802, which in turn shifts the voltage Vg in same direction as the change in the input voltage. Thus, if Vₒᵤₜ > Vref, then Vg is driven lower, which in turn causes the source follower SF1 to drive the output node Vₒᵤₜ lower. If Vₒᵤₜ < Vref, then Vg is driven higher, which in turn cases the source follower SF1 to drive the output node Vₒᵤₜ higher. The high gain of the error amplifier 702 ensures that, in steady state, Vg includes only small variations from a constant value.

### DATA DEPENDENT CURRENT COMPENSATION IN A VOLTAGE-MODE DRIVER

In serial communication systems, a large percentage of the total power is consumed in the transmitter, which must provide for adequate signal swing on a low-impedance channel while maintaining an appropriate source termination. In addition, the transmitter often includes equalization to compensate for frequency-dependent loss in the channel. The driver circuit in the transmitter often consumes the majority of the power of the transmitter. Driver circuits can be implemented as current-mode drivers or voltage-mode drivers. Voltage-mode drivers are known to consume far less power in comparison to current-mode drivers. For example, a voltage-mode driver can consume four times less DC power than a current-mode driver to provide the same output swing.

A transmitter can include a plurality of voltage-mode drivers coupled to a common output node. A voltage regulator provides a regulated supply voltage to the voltage-mode drivers. The voltage-mode drivers are driven by different input signals to implement equalization. Thus, the voltage-mode drivers draw a data-dependent current from the voltage regulator. Large swings in the average supply current can degrade the deterministic jitter of the transmitter.

Techniques for data-dependent current compensation in a voltage-mode driver are described. In an example, an output driver includes a plurality of output circuits coupled in parallel between a first voltage supply node and a second voltage supply node. Each of the plurality of output circuits includes a differential input that is coupled to receive a logic signal of a plurality of logic signals and a differential output that is coupled to a common output node. The output driver further includes at least one voltage regulator coupled to a respective at least one of the first voltage supply node and the second voltage supply node. The output driver further includes a current compensation circuit. The current compensation circuit includes a switch coupled in series with a current source, where the series combination of the switch and the current source is coupled between the first voltage supply node and the second voltage supply node. The current compensation circuit further includes an event detector coupled to the switch to supply an enable signal, where the event detector is configured to control state of the enable signal based on presence of a pattern in the plurality of logic signals.

In another example, a transmitter includes a finite impulse response (FIR) filter configured to supply a plurality of logic signals in response to input data. The transmitter further includes a pre-driver configured to couple the plurality of logic signals to an output driver. The output driver includes a plurality of output circuits coupled in parallel between a first voltage supply node and a second voltage supply node, where each of the plurality of output circuits including a differential input that is coupled to receive a logic signal of the plurality of logic signals and a differential output that is coupled to a common output node. The output driver further includes at least one voltage regulator coupled to a respective at least one of the first voltage supply node and the second voltage supply node. The output driver further includes a current compensation circuit. The current compensation circuit includes a switch coupled in series with a current source, where the series combination of the switch and the current source coupled between the first voltage supply node and the second voltage supply node. The current compensation circuit further includes an event detector coupled to the switch to supply an enable signal, where the event detector configured to control state of the enable signal based on presence of a pattern in the plurality of logic signals.

In another example, a method of controlling an output driver in a transmitter includes receiving a plurality of logic signals from an equalizer in the transmitter, coupling each of the plurality of logic signals to at least one of a plurality of output circuits of the output driver, the plurality of output circuits coupled between a first voltage supply node and a second voltage supply node, at least one of the first voltage supply node and the second voltage supply node coupled to a voltage regulator, detecting a pattern in the plurality of logic signals, and enabling at least one of a plurality of current sources coupled between the first voltage supply node and the second voltage supply node.

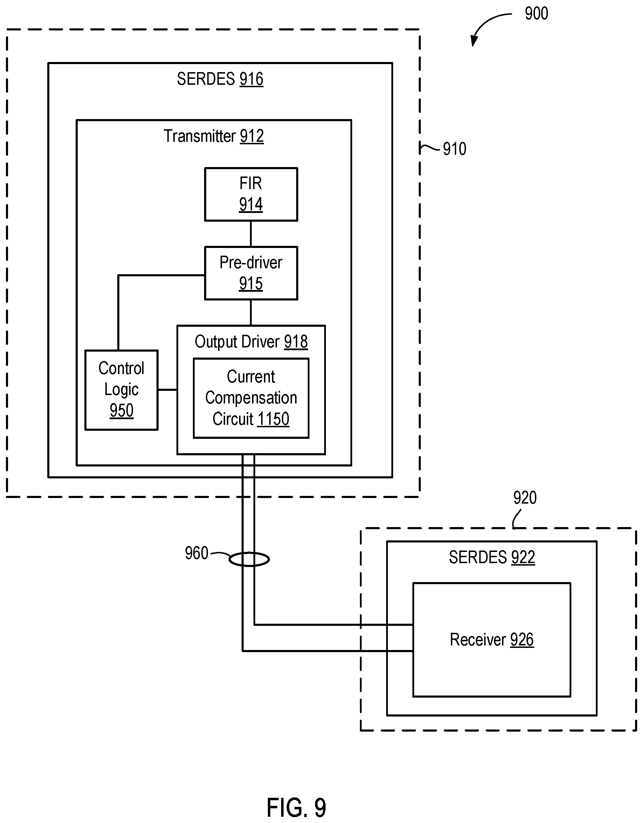

Fig. 9 is a block diagram depicting an example of a serial communication system 900. The serial communication system 900 comprises the transmitter 912 coupled to the receiver 926 over the transmission medium 960. The transmitter 912 can be part of a serializer-deserializer (SERDES) 916. The receiver 926 can be part of a SERDES 922. The transmission medium 960 comprises an electrical path between the transmitter 912 and the receiver 926 and can include printed circuit board (PCB) traces, vias, cables, connectors, decoupling capacitors, and the like. In examples, the transmission medium 960 includes a matched pair of transmission lines each having a characteristic impedance (Z0). The receiver of the SERDES 916, and the transmitter of the SERDES 922, are omitted for clarity. In some examples, the SERDES 916 can be disposed in an integrated circuit (IC) 910, and the SERDES 922 can be disposed in an IC 920.

in operation, the SERDES 916 serializes an input digital signal. As used herein, a digital signal is a sequence of k-bit codes, where k is a positive integer. A k-bit code may be referred to as a word (or data word). In specific examples, an 8-bit code may be referred to as a byte (or data byte). The number of codes per second is the data rate (also referred to as sample rate). A digital signal can also be conceptually viewed as a discrete-time, discrete-amplitude signal, where the amplitude of the signal at each discrete time is selected from 2k discrete values. As used herein a logic signal is a sequence of 1-bit codes. A logic signal can be viewed as a discrete-time, discrete amplitude signal, where the amplitude of the signal at each discrete time is selected from two states referred to as logic high (or logic "1") and logic low (or logic "0"). The input signal is serialized by decomposing each k-bit code at a discrete time into a sequence of j bits over j discrete times (referred to as serial data), where j is a positive integer greater than or equal to k. In some examples, data words provided by the input digital signal can be encoded prior to serialization using, for example, an 8B/10B encoder or any other line-coding scheme (e.g., j > k).

The SERDES 916 generates one or more logic signals to provide the serial data to the transmitter 912. The transmitter 912 drives the serial data onto the transmission medium 960 using a digital baseband modulation technique. In general, the serial data is divided into symbols. The transmitter 912 converts each symbol into an analog voltage mapped to the symbol. The transmitter 912 couples the analog voltage generated from each symbol to the transmission medium 960. In the examples described herein, the transmitter 912 uses a binary non-return-to-zero (NRZ) modulation scheme. In binary NRZ, a symbol is one bit of the serial data and two analog voltages are used to represent each bit. Those skilled in the art will appreciate that the techniques described herein can also be used with other digital baseband modulation techniques, such as pulse amplitude modulation (PAM), where a symbol includes a plurality of bits of the serial data.

In the example shown, the transmission medium 960 is a differential channel. Analog voltage is coupled to the transmission medium 960 using two complementary analog signals (referred to as positive and negative analog signals). For binary NRZ, a logic "0" of the serial data is represented by driving the transmission medium 960 with the positive analog signal at its lower voltage limit and the negative analog signal at its upper voltage limit. A logic "1" of the serial data is represented by driving the transmission medium 960 with the positive analog signal at its upper voltage limit and the negative analog signal to its lower voltage limit. Thus, the logic value of each bit of the serial data is based on the difference between the positive and negative analog signals, and not based on the level of either analog signal individually. The peak-to-peak difference between the positive analog signal and the negative analog signal is the voltage swing (also referred to as output swing or swing). The two complementary analog signals form a differential signal (also referred to as the transmitted signal).

The transmitter 912 includes a finite impulse response (FIR) filter 914, a pre-driver 915, an output driver 918, and control logic 950. The transmitter 912 is configured to process the serial data to pre-emphasize the transmitted signal and equalize the transmission medium 960. The FIR 914 can be used to mitigate inter-symbol interference (ISI) caused by the transmission medium 960. The transmission medium 960 degrades the signal quality of the transmitted signal. Channel insertion loss is the frequency-dependent degradation in signal power of the transmitted signal. When signals travel through a transmission line, the high frequency components of the transmitted signal are attenuated more than the low frequency components. In general, channel insertion loss increases as frequency increases. Signal pulse energy in the transmitted signal can be spread from one symbol period to another during propagation on the transmission medium 960. The resulting distortion is known as ISI. In general, ISI becomes worse as the speed of the communication system increases. The transmitter 912 uses pre-emphasis to equalize the transmission medium 960.

The output of the FIR filter 914 is coupled to an input of the pre-driver 915. An output of the pre-driver 915 is coupled to an input of the output driver 918. An output of the output driver 918 is coupled to the transmission medium 960. In operation, the FIR filter 914 receives the serial data. The FIR filter 914 includes a plurality of taps each providing a state of the serial data at different discrete times. In an example, the FIR filter 914 includes three taps, where one tap provides a current symbol of the serial data, another tap provides a delayed symbol of the serial data, and another tap provides an advanced symbol of the serial digital signal. The current, delayed, and advanced symbols are referred to as the main-cursor, the pre-cursor, and the post-cursor, respectively. The FIR filter 914 outputs a plurality of logic signals generated from the main-, pre-, and post-cursors, as described further below. While the FIR filter 914 is described has having three taps, in general, the FIR filter 914 can include a plurality of taps that provide a main-cursor, as well as one or more pre-cursors and/or one or more post-cursors.

The pre-driver 915 couples the logic signals output by the FIR filter 914 to the output driver 918. As discussed below, the output driver 918 is segmented and includes a plurality of output circuits coupled to the transmission medium 960. Each of the output circuits includes a series-source terminated (SST) output driver (e.g., a voltage-mode driver). The pre-driver 915 multiplexes the logic signals output by the FIR filter 914 among the output circuits to provide each of the main-, pre-, and post-cursors to a respective percentage of the output circuits. The numbers of the output circuits driven by the main-cursor, pre-cursor, and post-cursor are selected by the control logic 950 to provide a selected pre-emphasis to the transmitted signal for equalizing the transmission medium 960.

In the example, the output driver 918 couples a differential signal to the transmission medium 960. The output circuits in the output driver 918 draw a data-dependent current from voltage regulator(s). A change in the average supply current can degrade deterministic jitter (DJ) of the transmitter. Accordingly, the output driver 918 includes a current compensation circuit 1150 that ensures a constant average current is drawn from the voltage regulator(s). The current compensation circuit 1150 is described below.

While the SERDES 916 and the SERDES 922 are shown, in other examples, each of the transmitter 912 and/or the receiver 926 can be a stand-alone circuit not being part of a larger transceiver circuit. In some examples, the transmitter 912 and the receiver 926 can be part of one or more ICs, such as application specific integrated circuits (ASICs) or programmable ICs, such as field programmable gate arrays (FPGAs).

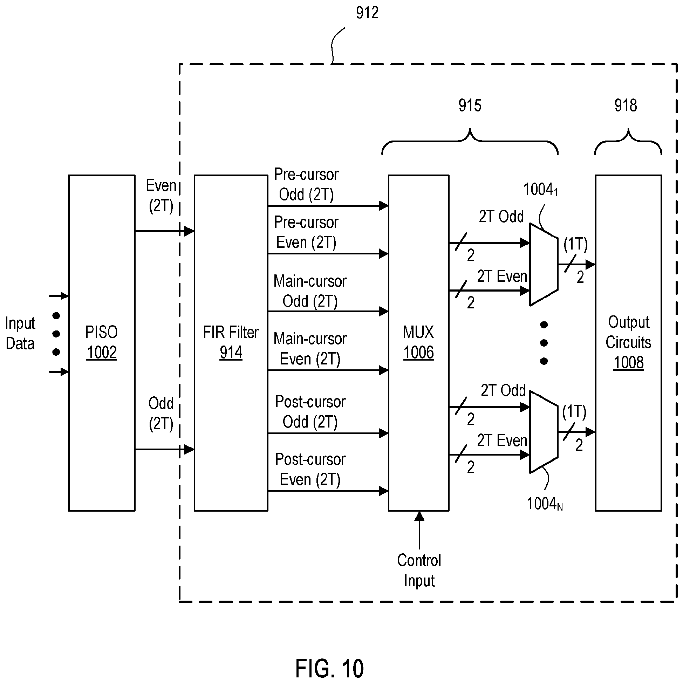

Fig. 10 is a block diagram depicting the transmitter 912 according to an example. An input of the transmitter 912 is coupled to a parallel-in-serial-out (PISO) circuit 1002 of the SERDES 916. The PISO circuit 1002 includes a parallel input to receive a digital signal to be transmitted. The PISO circuit 1002 serializes the digital signal to generate serial data. In the example, the PISO circuit 1002 outputs two logic signals referred to as the even signal and the odd signal. The even signal includes every even symbol of the serial data, and the odd signal includes every odd symbol of the serial data. In the examples described herein, each symbol is 1-bit of the serial data hence the terms symbol and bit are used interchangeably for these examples. If the transmitter 912 is configured to use a multi-bit symbol modulation scheme, such as PAM, each symbol would include a plurality of bits. The serial data includes a period T between symbols (a symbol rate 1/T). Each of the even signal and the odd signal has a period 2T (a data rate 1/(2T)).

The FIR filter 914 receives the even and odd signals output by the PISO 1002. In the example, the FIR filter 914 includes three taps that provide main-, pre-, and post-cursors for each of the even and odd signals (referred to as even and odd main-, pre-, and post-cursors). The FIR filter 914 outputs a plurality of logic signals that provide the even and odd main-, pre-, and post-cursors. In particular, the FIR filter 914 outputs logic signals for each of the odd pre-cursor ("pre-cursor odd"), the even pre-cursor ("pre-cursor even"), the odd main-cursor ("main-cursor odd"), the even main-cursor ("main-cursor even"), the odd post-cursor ("post-cursor odd"), and the even post-cursor ("post-cursor even"). Each of the logic signals output by the FIR filter 914 has a period 2T.

The pre-driver 915 includes multiplexers 10041 through 1004N (collectively multiplexers 1004) and multiplexing logic (MUX) 1006. Each of the multiplexers 1004 is a 2:1 multiplexer. The multiplexing logic 1006 includes inputs receiving the odd pre-cursor signal, the even pre-cursor signal, the odd main-cursor signal, the even main-cursor signal, the odd post-cursor signal, and the even post-cursor signal. The multiplexing logic 1006 includes 2T odd outputs coupled a first input of each of the multiplexers 1004 and a 2T even output coupled to a second input of each of the multiplexers 1004. Each 2T odd output of the multiplexing logic 1006 provides complementary logic signals for one of the pre-cursor, main-cursor, or post-cursor odd signals. Each 2T even output of the multiplexing logic 1006 provides complementary logic signals for one of the pre-cursor, main-cursor, or post-cursor even signals. The inputs of each multiplexer 1004 are alternately coupled to its output at a rate of 1/T. Thus, the output of each multiplexer 1004 provides complementary logic signals having a period T. For clarity, control inputs of the multiplexers 1004 are omitted from the drawing. Control inputs of the multiplexers 1004 are coupled to a clock signal to selects between the even and odd inputs at a rate of 1/T.

The output driver 918 includes a plurality of output circuits 1008 (e.g., N output circuits). As discussed above, each of the pre-cursor, main-cursor, and post-cursor signals is coupled to a certain percentage of the output circuits 1008 of the output driver 918. The MUX logic 1006 is configured to distribute the pre-, main-, and post-cursor signals among the multiplexers 1004, which feed the output circuits 1008. The MUX logic 1006 can couple logic signals for any of the pre-cursor, the main-cursor, or the post-cursor to any of the multiplexers 1004. The MUX logic 1006 includes a control input coupled to the control logic 950. The control logic 950 configures the MUX logic 1006 to couple logic signals for **the pre-cursor** to a selected number of the multiplexers 1004, logic signals for the post-cursor to a selected number of the multiplexers 1004, and logic signals for the main-cursor to a selected number of the multiplexers 1004. The multiplexers 1004 convert the 2T outputs of the multiplexing logic 1006 to 1T inputs of the output circuits 1008.

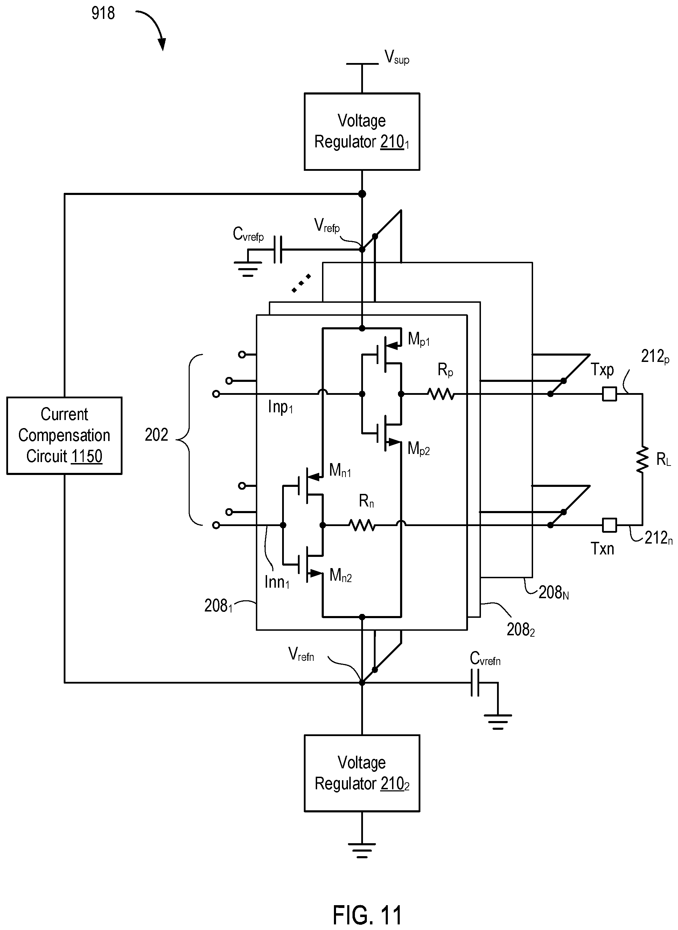

Fig. 11 is a schematic diagram depicting the output driver 918 according to an example. The output driver 918 is configured similarly to the output driver 118. The output driver 918 includes output circuits 208₁ through 208_{N} (where N is an integer greater than one), voltage regulators 210₁ and 210₂, and a current compensation circuit 1150. The voltage regulator 210₁ is coupled to the common node V_{refp}. The voltage regulator 210₁ controls the voltage at the node V_{refp} and supplies current to the output circuits 208. The voltage regulator 210₂ is coupled to the common node V_{refn}. The voltage regulator 210₂ controls the voltage at the node V_{refn} and sinks current from the output circuits 208 (e.g., supplies a negative current to the output circuits 208). The voltage regulator 210₁ is coupled to a first supply voltage Vₛᵤₚ, and the voltage regulator 210₂ is coupled to a second supply voltage (e.g., electrical ground).

The voltage regulators 210 set the swing of the output driver 918. The differential peak-to-peak swing is based on V_{refp} - V_{refn}. With the dual regulators 210₁ and 210₂ in the output driver 918, the swing and common-mode can be set independently. For example, for a common-mode of 0.45 V and an output swing of 0.6 V, V_{refp} is set to 0.75 V and V_{refn} is set to 0.15 V. In the output driver 918, equalization can be implemented by driving a different number of the output circuits 208 with different main/pre/post cursor signals. With the dual-regulator approach, the swing is changed by adjusting the regulator voltage. Thus, equalization control is independent of the swing control. This allows for high FIR resolution even in low-swing mode.

The output circuits 208 draw a data-dependent current from the voltage regulators 210. The current drawn from the voltage regulators 210 is inversely proportional to the magnitude of the differential output voltage. The magnitude of the differential output voltage itself depends on the state of the main-, pre-, and post-cursors. When the main-cursor has a different state than the pre-cursor and/or post-cursor, the magnitude of the differential output voltage is large and the supplied current is small. That is, the magnitude of the differential output **voltage is** large and the supplied current is small whenever a bit of the main-cursor (1T) signal is different from its previous and/or subsequent bit. Conversely, when the main-cursor has the same state as the pre-cursor and/or post-cursor, the magnitude of the differential output voltage is small and the supplied current is large. That is, the magnitude of the differential output voltage is small and the supplied current is large whenever a bit of the main-cursor (1T) signal is the same as its previous and/or subsequent bit. The difference between the "large" current and the "small" current (i.e., the current swing) can be large enough to degrade the deterministic jitter of the transmitter 912.

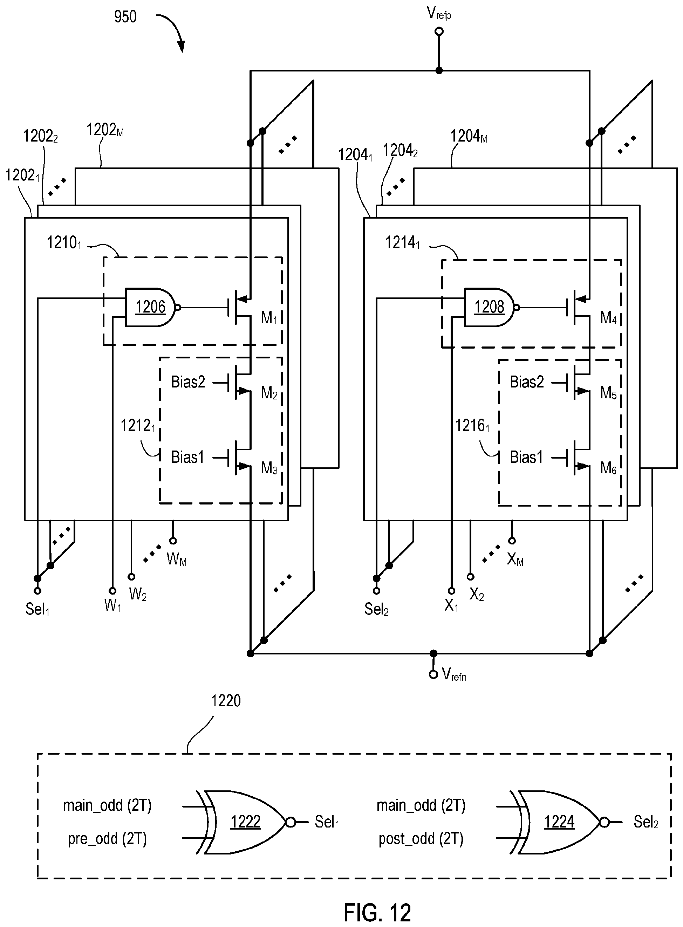

The current compensation circuit 1150 is coupled between the common nodes V_{refp} and V_{refn}. The current compensation circuit 1150 is controllable (e.g., using the control logic 950) to draw a selected current from the voltage regulator 210₁ (and sinked by the voltage regulator 210₂). The control logic 950 can control the current compensation circuit 1150 to equalize the average current supplied by the voltage regulator 210₁ and sinked by the voltage regulator 2502. The current compensation circuit 1150 is controlled to minimize the current swing and maintain the deterministic jitter performance of the transmitter 912. An example of the current compensation circuit 1150 is described below with respect to Fig. 12.

Fig. 12 is a schematic diagram depicting the current compensation circuit 1150 according to an example. In general, the current compensation circuit 1150 includes an event detector 1220 and a branch circuit 1202 that is coupled between the common nodes V_{refp} and V_{refn}. The branch circuit 1202 includes a switch 1210 coupled to a current source 1212. The series combination of the switch 1210 and the current source 1212 is coupled between the common nodes V_{refp} and V_{refn}. The event detector 1220 is coupled to the switch 1210 to supply a logic signal referred to as an enable signal (Sell). The event detector 1220 controls the state of the enable signal (Sel1) based on presence of a pattern in logic signals output by the FIR filter 914.

In particular, the event detector 1220 detects a pattern in a plurality of 2T logic signals output by the FIR filter 914 that occurs when the state of a current symbol of the serial data is different from that of a delayed symbol and/or advanced symbol. Upon detecting the pattern, the event detector 1220 controls the enable signal (Sel1) to close the switch 1210, which couples the current source 1212 between the common nodes V_{refp} and V_{refn}. The current source 1212 is controlled to draw a known amount of current from the voltage regulators 210. Upon absence of the pattern, the event detector 1220 controls the enable signal (Sel1) to open the switch 1210, which decouples the current source 1212 between the common nodes V_{refp} and V_{refn}. In this manner, the average current drawn from the voltage regulators 210 is controlled based on the state of the serial data to minimize its effect on deterministic jitter of the transmitter 912.

In an example, the current compensation circuit 1150 generally includes M branch circuits 1202 coupled in parallel, e.g., branch circuits 1202₁ through 1202_{M}, where M is a positive integer. The switch 1210 generally includes switch circuits 1210₁ through 1210_{M}. Likewise, the current source 1212 includes current source circuits 1212₁ through 1212_{M}. The branch circuits 1202₁ through 1202_{M} respectively include the switch circuits 1210₁ through 1210_{M} and the current source circuits 1212₁ through 1212_{M}. When M is greater than one, the switch circuits 1210₁ through 1210_{M} are responsive to the enable signal (Sel1) and individual enable signals W₁ through W_{M}, which are logic signals that can be generated by the control logic 950. In operation, when the event detector 1220 detects the pattern, the event detector 1220 enables a selected number of the current source circuits 1212₁ through 1212_{M} as controlled by the control logic 950. The individual enable signals W₁ through W_{M} thus control the weight of the current drawn by the branch circuits 1202₁ through 1202_{M}. The branch circuits 1202₁ through 1202_{M} implement a current-output digital-to-analog converter (DAC) that generates an analog current in response to the enable signal (Sell) and a digital signal formed by the logic signals W₁ through W_{M} (e.g., an M-bit digital code selecting from 2M current levels). The strength of the DAC can be programmed to match the strength of the equalization.

The event detector 1220 includes a logic gate 1222 configured to generate the enable signal (Sell). In the example shown, the logic gate 1222 is an exclusive NOR (XNOR) gate. One input of the logic gate 1222 is coupled to receive the 2T odd main-cursor (designated main_odd (2T)). Another input of the logic gate 1222 is coupled to receive the 2T odd pre-cursor (designated pre_odd (2T)). The logic signal output by the logic gate 1222 is logic "0" when state of the odd main-cursor signal is different than the state of the odd pre-cursor signal. The logic signal output by the logic gate 1222 is logic "1" when the state of the odd main-cursor signal is the same as the state of the odd pre-cursor signal. As such, the logic gate 1222 detects a pattern where state of the odd main-cursor signal is different than the state of the odd pre-cursor signal, which indicates that a bit of the 1T main-cursor signal is different from its previous bit. Upon detecting the pattern, the logic gate 1222 asserts the enable signal, which enables activation one or more branch circuits 1202. Since the current compensation circuit 1150 equalizes the average current drawn from the supplies, the current compensation circuit 1150 can use 2T signals to detect the pattern, rather than the 1T signals, which is more energy efficient.

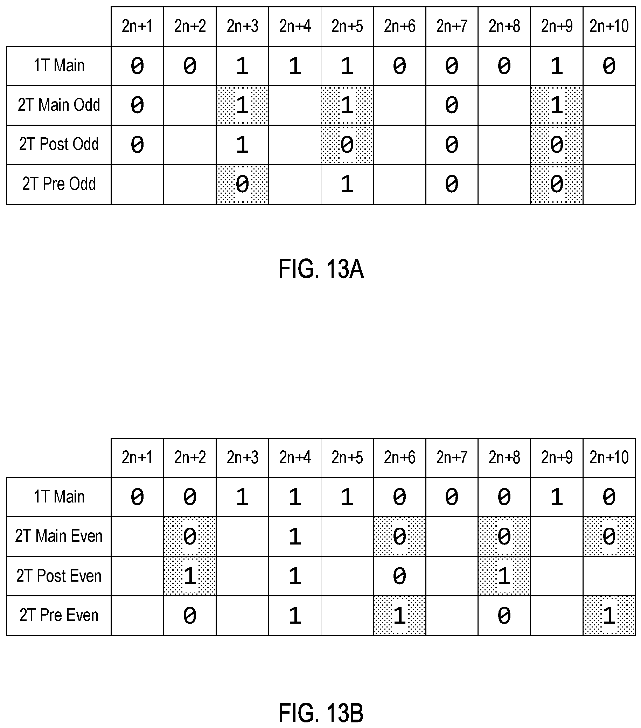

Fig. 13A is a table illustrating an example portion of a 1T main-cursor signal and its associated 2T odd signals. In the example, the 1T main-cursor signal has a bit sequence 0011100010 for discrete times 2n+1 through 2n+10, where n is an integer. The 2T odd main-cursor signal includes the bits from the odd discrete times 2n+1, 2n+3,...,2n+9, which is the bit pattern 01101. The 2T odd post-cursor signal is the bit pattern 01000 for odd discrete times 2n+1, 2n+3,...,2n+9. The 2T odd pre-cursor signal is the bit pattern 0100 for the odd discrete times 2n+3, 2n+5,...,2n+9. The shaded boxes show where the 2T odd main-cursor is different from the 2T odd pre-cursor and/or the 2T odd post-cursor. This occurs at discrete times 2n+3, 2n+5, and 2n+9. The logic gate 1222 in the example of Fig. 12 asserts the enable signal (Sell) at discrete times 2n+3 and 2n+9 when detecting a state difference between the 2T odd main-cursor and the 2T odd pre-cursor.

Returning to Fig. 12, the logic gate 1222 looks for a pattern indicative of a bit of the 1T main-cursor signal being different from its previous bit. The event detector 1220 can also include a logic gate 1224 that looks for a pattern indicative of a bit of the 1T main-cursor signal being different from its subsequent bit. In the example shown, the logic gate 1224 is an XNOR gate. The logic gate 1224 outputs a logic signal referred to as an enable signal (Sel2). One input of the logic gate 1224 is coupled to receive main_odd (2T). Another input of the logic gate 1224 is coupled to receive the 2T odd post-cursor (designated post_odd (2T)). The logic signal output by the logic gate 1224 is logic "0" when state of the odd main-cursor signal is different than the state of the odd post-cursor signal. The logic signal output by the logic gate 1224 is logic "1" when the state of the odd main-cursor signal is the same as the state of the odd post-cursor signal. As such, the logic gate 1224 detects a pattern where state of the odd main-cursor signal is different than the state of the odd post-cursor signal, which indicates that a bit of the 1T main-cursor signal is different from its subsequent bit. Upon detecting the pattern, the logic gate 1224 asserts the enable signal (Sel2). In the example of Fig. 13A, the logic gate 1224 asserts the enable signal (Sel2) at discrete times 2n+5 and 2n+9.

The enable signal (Sel2) is used to control another resistance coupled in parallel with the current source 1212. In particular, the current compensation circuit 1150 includes at least one branch circuit 1204 that is coupled between the common nodes V_{refp} and V_{refn}. The branch circuit(s) 1204 provide a switch 1214 coupled in series with a current source 1216. The series combination of the switch 1214 and the current source 1216 is coupled between the common nodes V_{refp} and V_{refn}. The event detector 1220 is coupled to the switch 1214 to supply the enable signal (Sel2).

In an example, the current compensation circuit 1150 generally includes M branch circuits 1204 coupled in parallel, e.g., branch circuits 1204, through 1204_{M}. The switch 1214 generally includes switch circuits 1214₁ through 1214_{M}. Likewise, the current source 1216 includes current source circuits 1216₁ through 1216_{M}. The branch circuits 1204₁ through 1204_{M} respectively include the switch circuits 1214₁ through 1214_{M} and the current source circuits 1216₁ through 1216_{M}. When M is greater than one, the switch circuits 1214₁ through 1214_{M} are responsive to the enable signal (Sel2) and individual enable signals X₁ through X_{M}, which are logic signals that can be generated by the control logic 950. The branch circuits 1204₁ through 1204_{M} implement another current-output DAC that generates an analog current in response to the enable signal (Sel2) and a digital signal formed by the logic signals X₁ through X_{M} (e.g., an M-bit digital code selecting from 2M current levels).

In an example, each switch circuit 1210₁ through 1210_{M} includes a logic gate 1206 and a transistor M₁. In the example shown, the logic gate 1206 is a NAND gate and the transistor M₁ is a p-channel FET, such as a PMOS transistor. An output of the logic gate 1206 is coupled to a gate of the transistor M₁. A source of the transistor M₁ is coupled to the common node V_{refp}. A drain of the transistor M₁ is coupled to a respective current source circuit 12121 through 1212_{M}. One input of the logic gate 1206 receives the enable signal (Sell). Another input of the logic gate 1206 receives one of the individual enable signals W<M:1>.

Likewise, each switch circuit 1214₁ through 1214_{M} includes a logic gate 1208 and a transistor M₄. In the example shown, the logic gate 1208 is a NAND gate and the transistor M₄ is a p-channel FET, such as a PMOS transistor. An output of the logic gate 1208 is coupled to a gate of the transistor M₄. A source of the transistor M₄ is coupled to the common node V_{refp}. A drain of the transistor M₄ is coupled to a respective current source circuit 1216₁ through 1216_{M}. One input of the logic gate 1208 receives the enable signal (Sel2). Another input of the logic gate 1208 receives one of the individual enable signals X<M:1>.

In an example, each current source circuit 1212₁ through 1212_{M} includes a transistor M₂ and a transistor M₃. A drain of the transistor M₂ is coupled to a drain of the transistor M₁. A source of the transistor M₂ is coupled to a drain of the transistor M₃. A source of the transistor M₃ is coupled to the common node Vᵣₑₜₙ. A gate of the transistor M₂ is coupled to a bias node (Bias2). A gate of the transistor M₃ is coupled to a bias node (Bias1). Likewise, each current source circuit 1216₁ through 1216_{M} includes a transistor M₅ and a transistor M₆. A drain of the transistor M₅ is coupled to a drain of the transistor M₄. A source of the transistor M₅ is coupled to a drain of the transistor M₆. A source of the transistor M₆ is coupled to the common node V_{refn}. A gate of the transistor M₅ is coupled to a bias node (Bias2). A gate of the transistor M₆ is coupled to a bias node (Bias1). The transistors M₂, M₃, M₅, and M₆ are n-channel FETs, such as NMOS transistors. The transistors M₂, M₃, M₅, and M₆ are biased into saturation by the bias voltages Bias1 and Bias2.

In the example of Fig. 12, the event detector 1220 compares the 2T odd main-cursor signal with the respective 2T odd pre- and post-cursor signals. In other examples, the event detector 1220 can compare the 2T even main-cursor signal with the respective 2T even pre- and post-cursor signals. Fig. 13B is a table illustrating an example portion of a 1T main-cursor signal and its associated 2T even signals. In the example, the 1T main-cursor signal has the same bit sequence 0011100010 for discrete times 2n+1 through 2n+10 as shown in Fig. 13A. The 2T even main-cursor signal includes the bits from the even discrete times 2n+2, 2n+4,...,2n+10, which is the bit pattern 01000. The 2T even post-cursor signal is the bit pattern 1101 for even discrete times 2n+2, 2n+4,...,2n+8. The 2T even pre-cursor signal is the bit pattern 01101 for the even discrete times 2n+2, 2n+4,...,2n+10. The shaded boxes show where the 2T even main-cursor is different from the 2T even pre-cursor and/or the 2T even post-cursor. This occurs at discrete times 2n+2, 2n+4, 2n+6, 2n+8, and 2n+10. The event detector 1220 can be configured to assert the enable signal (Sell) at discrete times 2n+6 and 2n+10, and assert the enable signal (Sel2) at discrete times 2n+2 and 2n+8.

While the foregoing is directed to specific examples, other and further examples may be devised without departing from the basic scope thereof, and the scope thereof is determined by the claims that follow.

## Claims

1. A driver circuit, comprising:
a plurality of output circuits (208) coupled between a differential input (202) and a differential output (Txp, Txn) and in parallel between a first common node (V_{refp}) and a second common node (V_{refn}), each of the plurality of output circuits (208) comprising:
a series combination of a pair of inverters (Mₚ₁, Mₚ₂, Mₙ₁, Mₙ₂) and a pair of resistors (Rₚ, Rₙ), coupled between the differential input (Inp, Inn) and the differential output (Txp, Txn);
first source terminals of the pair of inverters (Mₚ₁, Mₚ₂, Mₙ₁, Mₙ₂) coupled to the first common node (V_{refp}); and
second source terminals of the pair of inverters (Mₚ₁, Mₚ₂, Mₙ₁, Mₙ₂) coupled to the second common node (V_{refn});
a first voltage regulator (210₁) having an output coupled to the first common node (V_{refp}) of the plurality of output circuits;
a second voltage regulator (210₂) having an output coupled to the second common node (V_{refn}) of the plurality of circuits; and
a current compensation circuit (206, 1150) comprising a plurality of circuits (206₁ - 206_{M}, 1202₁-1202ₘ, 1204₁-1204ₘ) coupled in parallel between the first common node (V_{refp}) and the second common node (V_{refn}) to provide a current path between the outputs of the first voltage regulator (210₁) and the second voltage regulator (210₂), the current compensation circuit (206) configured to draw a selectable current from the first voltage regulator (210-1) to improve return loss, wherein, for each of the plurality of circuits (206₁-206_{M}, 1202₁-1202_{M}, 1204₁-1204_{M}), a gate of a first transistor (M₁) is coupled to receive a signal of an enable input (EN₁, Sel1, Sel₂), a gate of a second transistor (M₂) is coupled to receive a signal of a first bias input (V₁, Bias2), a gate of the third transistor (M₃) is coupled to receive a signal of a second bias input (V₂, Bias1), and the first transistor (M₁) the second transistor (M₂), and the third transistor (M₃) are serially connected.

2. The driver circuit of claim 1, wherein the first voltage regulator (210₁) comprises:
a first transistor (M_{vrefp}) coupled between a supply voltage source and the first common node (V_{refp}) of the plurality of outputs circuits; and
a first operational amplifier (A_{vrefp}) having a first input coupled to a first reference voltage source, a second input coupled to the first common node of the plurality of output circuits, and an output coupled to a gate of the first transistor.

3. The driver circuit of claim 2, wherein the second voltage regulator (210₂) comprises:
a second transistor (M_{vrefn}) coupled between a ground source and the second common node of the plurality of outputs circuits; and
a second operational amplifier (A_{vrefn}) having a first input coupled to a second reference voltage source, a second input coupled to the second common node of the plurality of output circuits, and an output coupled to a gate of the second transistor.

4. The driver circuit of claim 1, wherein the second voltage regulator (210₂) comprises:
an output transistor (M_{power}) that includes a source coupled to a first voltage supply node and a drain coupled to an output node;
a first transistor (M_{SF1}) that includes a source coupled to the output node;
a second transistor (M_{SF2}) that includes a source coupled to a gate of the output transistor and a drain coupled to a second voltage supply node;
a resistor (R₁) coupled between the second voltage supply node and a first node that includes the drain of the first transistor (M_{SF1}) and a gate of the second transistor (M_{SF2}); and
an error amplifier (702) that includes a first input coupled to a reference voltage node, a second input coupled to the output node, and an output coupled to a gate of the first transistor.

5. The driver circuit of claim 4, wherein the error amplifier (702) includes a folded cascode amplifier that includes: a source-coupled transistor pair, which includes a source node coupled to a current source (I_{bais2}) and drains coupled to an output circuit, wherein the output circuit is disposed between the first voltage supply node and the second voltage supply node, and wherein gates of the source-coupled transistor pair are coupled to the reference voltage node (V_{ref}) and the output node (Vₒᵤₜ), respectively.

6. The driver circuit of claim 1, wherein the current compensation circuit (206) includes:
a switch (1210) coupled in series with a current source (1212), the series combination of the switch (1210) and the current source (1212) coupled between the first common node (Vrefp) and the second common node (Vrefn); and
an event detector (1220) coupled to the switch to supply an enable signal, the event detector (1220) configured to control state of the enable signal based on presence of a pattern in a plurality of logic signals generated by a filter (914) coupled to the plurality of output circuits.

7. The driver circuit of claim 6, wherein:
the current source (1212) includes a plurality of current source circuits (1212₁ - 1212_{M}) and the switch (1210) includes a plurality switch circuits (1210₁ - 1210_{M}) respectively coupled in series with the plurality of current source circuits (1212₁ - 1212_{M});
the enable signal is a common enable signal; and
each of the plurality of switch circuits (1210₁ - 1210_{M}) is responsive to the common enable signal and a respective one of a plurality of individual enable signals.

8. The driver circuit of claim 7, wherein each of the plurality of switch circuits (1210₁ - 1210_{M}) includes:
a transistor coupled in series with a respective one of the plurality of current source circuits (1212₁ - 1212_{M}) and a logic gate (1222) coupled to a gate of the transistor, the logic gate (1222) having a first input coupled to receive the common enable signal and a second input coupled to receive a respective one of the plurality of individual enable signals.

9. The driver circuit of claim 8, wherein each of the plurality of current source circuits (1212₁ - 1212_{M}) of the current source (1212) includes:
a first transistor in series with a second transistor, the first transistor including a gate coupled to a first bias node and the second transistor including a gate coupled to a second bias node.

10. The driver circuit of claim 1, further comprising:
a first capacitor (C_{vrefp}) coupled between the first common node (V_{refp}) of the plurality of output circuits and a ground source; and
a second capacitor (C_{vrefn}) coupled between the second common node of the plurality of output circuits and the ground source.

11. The driver circuit of claim 1, wherein the differential output (Txp, Txn) of the plurality of output circuits is coupled to a pair of transmission lines (212ₚ, 212ₙ).

12. A method of controlling a driver circuit in a transmitter, comprising:
receiving a plurality of outputs of an equalizer in the transmitter;
coupling each of the plurality of outputs of the equalizer to at least one of a plurality of output circuits (208) of the driver circuit;
coupling outputs of first and second voltage regulators (210₁, 210₂) to the plurality of output circuits (208) via a first common node (V_{refp}) and a second common node (V_{refn}) and enabling the second voltage regulator (210₂); and
enabling at least one of a plurality of current compensation circuits (206) coupled in parallel between the first common node (V_{refp}) and a second common node (V_{refn}) to provide a current path between the outputs of the first and second voltage regulator (210₁, 210₂), the plurality of current compensation circuits (206) configured to draw a selectable current from the first voltage regulator (210₁) to improve return loss, wherein, for each of the plurality of circuits (206₁-206_{M}, 1202₁-1202_{M}, 1204₁-1204_{M}), a gate of a first transistor (M₁) is coupled to receive a signal of an enable input (EN₁, Sel₁, Sel₂), a gate of a second transistor (M₂) is coupled to receive a signal of a first bias input (V₁, Bias2), a gate of the third transistor (M₃) is coupled to receive a signal of a second bias input (V₂, Bias1), and the first transistor (M₁) the second transistor (M₂), and the third transistor (M₃) are serially connected;
wherein the plurality of output circuits (208) is coupled between a differential input (Inp, Inn) and a differential output (Txp, Txn) and in parallel between a first common node (V_{refp}) and a second common node (V_{refn}), wherein each of the plurality of output circuits (208) comprises a series combination of a pair of enable circuits, a pair of inverters (Mₚ₁, Mₚ₂, Mₙ₁, Mₙ₂), and a pair of resistors (Rₚ, Rₙ), coupled between the differential input (Inn, Ipp) and the differential output (Txp, Txn); a first transistor coupled between the first common node (V_{refp}) and first source terminals of the pair of inverters (Mₚ₁, Mₚ₂, Mₙ₁, Mₙ₂); and a second transistor coupled between the second common node (V_{refn}) and second source terminals of the pair of inverters (Mₚ₁, Mₚ₂, Mₙ₁, Mₙ₂).

13. The method of claim 12, wherein the method further comprises:
disabling at least one of the plurality of output circuits (208); and
adjusting a gate-to-source voltage of each of the first transistor and the second transistor in each of the plurality of circuits (208) based on feedback from first and second replica output circuits.

## Patentansprüche

1. Treiberschaltung, umfassend:
eine Vielzahl von Ausgangsschaltungen (208), die zwischen einem Differentialeingang (202) und einem Differentialausgang (Txp, Txn) und parallel zwischen einem ersten gemeinsamen Knoten (V_{refp}) und einem zweiten gemeinsamen Knoten (V_{refn}) gekoppelt sind, wobei jede der Vielzahl von Ausgangsschaltungen (208) umfasst:
eine Reihenkombination aus einem Paar von Invertern (Mₚ₁, Mₚ₂, Mₙ₁, Mₙ₂) und einem Paar von Widerständen (Rₚ, Rₙ), die zwischen dem Differentialeingang (Inp, Inn) und dem Differentialausgang (Txp, Txn) gekoppelt sind;
erste Source-Anschlüsse des Paars von Invertern (Mₚ₁, Mₚ₂, Mₙ₁, Mₙ₂), die mit dem ersten gemeinsamen Knoten (V_{refp}) gekoppelt sind; und
zweite Source-Anschlüsse des Paars von Invertern (Mₚ₁, Mₚ₂, Mₙ₁, Mₙ₂), die mit dem zweiten gemeinsamen Knoten (V_{refn}) gekoppelt sind;
einen ersten Spannungsregler (210₁) mit einem Ausgang, der mit dem ersten gemeinsamen Knoten (V_{refp}) der Vielzahl von Ausgangsschaltungen gekoppelt ist;
einen zweiten Spannungsregler (210₂) mit einem Ausgang, der mit dem zweiten gemeinsamen Knoten (V_{refn}) der Vielzahl von Schaltungen gekoppelt ist; und
eine Stromkompensationsschaltung (206, 1150), die eine Vielzahl von Schaltungen (206₁ bis 206_{M}, 1202₁ bis 1202ₘ, 1204₁ bis 1204ₘ) umfasst, die parallel zwischen dem ersten gemeinsamen Knoten (V_{refp}) und dem zweiten gemeinsamen Knoten (V_{refn}) gekoppelt sind, um einen Strompfad zwischen den Ausgängen des ersten Spannungsreglers (210₁) und des zweiten Spannungsreglers (210₂) bereitzustellen, wobei die Stromkompensationsschaltung (206) konfiguriert ist, um einen wählbaren Strom von dem ersten Spannungsregler (210-1) zu ziehen, um die Rückflussdämpfung zu verbessern, wobei für jede der Vielzahl von Schaltungen (206₁ bis 206_{M}, 1202₁ bis 1202_{M}, 1204₁ bis 1204_{M}) ein Gate eines ersten Transistors (M₁) gekoppelt ist, um ein Signal eines Freigabeeingangs (EN₁, Sel1, Sel₂) zu empfangen, ein Gate eines zweiten Transistors (M₂) gekoppelt ist, um ein Signal eines ersten Vorspannungseingangs (V₁, Vorspannung2) zu empfangen, ein Gate des dritten Transistors (M₃) gekoppelt ist, um ein Signal eines zweiten Vorspannungseingangs (V₂, Vorspannung1) zu empfangen, und der erste Transistor (M₁), der zweite Transistor (M₂) und der dritte Transistor (M₃) in Reihe verbunden sind.

2. Treiberschaltung nach Anspruch 1, wobei der erste Spannungsregler (210₁) umfasst:
einen ersten Transistor (M_{vrefp}), der zwischen einer Versorgungsspannungsquelle und dem ersten gemeinsamen Knoten (V_{refp}) der Vielzahl von Ausgangsschaltungen gekoppelt ist; und
einen ersten funktionellen Verstärker (A_{vrefp}) mit einem ersten Eingang, der mit einer ersten Referenzspannungsquelle gekoppelt ist, einem zweiten Eingang, der mit dem ersten gemeinsamen Knoten der Vielzahl von Ausgangsschaltungen gekoppelt ist, und einem Ausgang, der mit einem Gate des ersten Transistors gekoppelt ist.

3. Treiberschaltung nach Anspruch 2, wobei der zweite Spannungsregler (210₂) umfasst:
einen zweiten Transistor (M_{vrefn}), der zwischen einer Massequelle und dem zweiten gemeinsamen Knoten der Vielzahl von Ausgangsschaltungen gekoppelt ist; und
einen zweiten funktionellen Verstärker (A_{vrefn}) mit einem ersten Eingang, der mit einer zweiten Referenzspannungsquelle gekoppelt ist, einem zweiten Eingang, der mit dem zweiten gemeinsamen Knoten der Vielzahl von Ausgangsschaltungen gekoppelt ist, und einem Ausgang, der mit einem Gate des zweiten Transistors gekoppelt ist.

4. Treiberschaltung nach Anspruch 1, wobei der zweite Spannungsregler (210₂) umfasst:
einen Ausgangstransistor (M_{Leistung}), der eine Source, die mit einem ersten Spannungsversorgungsknoten gekoppelt ist, und einen Drain, der mit einem Ausgangsknoten gekoppelt ist, einschließt;
einen ersten Transistor (M_{SF1}), der eine Source, die mit dem Ausgangsknoten gekoppelt ist, einschließt;
einen zweiten Transistor (M_{SF2}), der eine Source, die mit einem Gate des Ausgangstransistors gekoppelt ist, und einen Drain, der mit einem zweiten Spannungsversorgungsknoten gekoppelt ist, einschließt;
einen Widerstand (R₁), der zwischen dem zweiten Spannungsversorgungsknoten und einem ersten Knoten gekoppelt ist, der den Drain des ersten Transistors (M_{SF1}) und ein Gate des zweiten Transistors (M_{SF2}) einschließt; und
einen Fehlerverstärker (702), der einen ersten Eingang, der mit einem Referenzspannungsknoten gekoppelt ist, einen zweiten Eingang, der mit dem Ausgangsknoten gekoppelt ist, und einen Ausgang, der mit einem Gate des ersten Transistors gekoppelt ist, einschließt.

5. Treiberschaltung nach Anspruch 4, wobei der Fehlerverstärker (702) einen gefalteten Kaskodenverstärker einschließt, der einschließt: ein sourcegekoppeltes Transistorpaar, das einen Source-Knoten, der mit einer Stromquelle (I_{bais2}) gekoppelt ist, und Drains, die mit einer Ausgangsschaltung gekoppelt sind, einschließt, wobei die Ausgangsschaltung zwischen dem ersten Spannungsversorgungsknoten und dem zweiten Spannungsversorgungsknoten angeordnet ist und wobei Gates des sourcegekoppelten Transistorpaars mit dem Referenzspannungsknoten (V_{ref}) bzw. dem Ausgangsknoten (V_{Aus}) gekoppelt sind.

6. Treiberschaltung nach Anspruch 1, wobei die Stromkompensationsschaltung (206) einschließt:
einen Schalter (1210), der in Reihe mit einer Stromquelle (1212) gekoppelt ist, wobei die Reihenkombination des Schalters (1210) und der Stromquelle (1212) zwischen dem ersten gemeinsamen Knoten (Vrefp) und dem zweiten gemeinsamen Knoten (Vrefn) gekoppelt ist; und
einen Ereignisdetektor (1220), der mit dem Schalter gekoppelt ist, um ein Freigabesignal bereitzustellen, wobei der Ereignisdetektor (1220) konfiguriert ist, um den Zustand des Freigabesignals basierend auf dem Vorhandensein eines Musters in einer Vielzahl von Logiksignalen, die durch einen Filter (914), der mit der Vielzahl von Ausgangsschaltungen gekoppelt ist, erzeugt werden, zu steuern.

7. Treiberschaltung nach Anspruch 6, wobei:
die Stromquelle (1212) eine Vielzahl von Stromquellenschaltungen (1212₁ bis 1212_{M}) einschließt und der Schalter (1210) eine Vielzahl von Schalterschaltungen (1210₁ bis 1210_{M}), die jeweils in Reihe mit der Vielzahl von Stromquellenschaltungen (1212₁ bis 1212_{M}) gekoppelt sind, einschließt;
das Freigabesignal ein gemeinsames Freigabesignal ist und
jede der Vielzahl von Schalterschaltungen (1210₁ bis 1210_{M}) auf das gemeinsame Freigabesignal und ein jeweiliges einer Vielzahl von einzelnen Freigabesignalen reagiert.

8. Treiberschaltung nach Anspruch 7, wobei jede der Vielzahl von Schalterschaltungen (1210₁ bis 1210_{M}) einschließt:
einen Transistor, der in Reihe mit einer jeweiligen der Vielzahl von Stromquellenschaltungen (1212₁ bis 1212_{M}) gekoppelt ist, und ein Logikgatter (1222), das mit einem Gate des Transistors gekoppelt ist, wobei das Logikgatter (1222) einen ersten Eingang, der gekoppelt ist, um das gemeinsame Freigabesignal zu empfangen, und einen zweiten Eingang, der gekoppelt ist, um ein jeweiliges der Vielzahl von einzelnen Freigabesignalen zu empfangen, aufweist.

9. Treiberschaltung nach Anspruch 8, wobei jede der Vielzahl von Stromquellenschaltungen (1212₁ bis 1212_{M}) der Stromquelle (1212) einschließt:
einen ersten Transistor in Reihe mit einem zweiten Transistor, wobei der erste Transistor ein Gate einschließt, das mit einem ersten Vorspannungsknoten gekoppelt ist, und der zweite Transistor ein Gate einschließt, das mit einem zweiten Vorspannungsknoten gekoppelt ist.

10. Treiberschaltung nach Anspruch 1, ferner umfassend:
einen ersten Kondensator (C_{vrefp}), der zwischen dem ersten gemeinsamen Knoten (V_{refp}) der Vielzahl von Ausgangsschaltungen und einer Massequelle gekoppelt ist; und
einen zweiten Kondensator (C_{vrefn}), der zwischen dem zweiten gemeinsamen Knoten der Vielzahl von Ausgangsschaltungen und der Massequelle gekoppelt ist.

11. Treiberschaltung nach Anspruch 1, wobei der Differentialausgang (Txp, Txn) der Vielzahl von Ausgangsschaltungen mit einem Paar von Übertragungsleitungen (212ₚ, 212ₙ) gekoppelt ist.

12. Verfahren zum Steuern einer Treiberschaltung in einem Sender, umfassend:
Empfangen einer Vielzahl von Ausgängen eines Entzerrers im Sender;
Koppeln jedes der Vielzahl von Ausgängen des Entzerrers mit mindestens einer aus einer Vielzahl von Ausgangsschaltungen (208) der Treiberschaltung;
Koppeln von Ausgängen des ersten und des zweiten Spannungsreglers (210₁, 210₂) mit der Vielzahl von Ausgangsschaltungen (208) über einen ersten gemeinsamen Knoten (V_{refp}) und einen zweiten gemeinsamen Knoten (V_{refn}) und Aktivieren des zweiten Spannungsreglers (210₂) und
Aktivieren mindestens einer aus einer Vielzahl von Stromkompensationsschaltungen (206), die parallel zwischen dem ersten gemeinsamen Knoten (V_{refp}) und einem zweiten gemeinsamen Knoten (V_{refn}) gekoppelt sind, um einen Strompfad zwischen den Ausgängen des ersten und des zweiten Spannungsreglers (210₁, 210₂) bereitzustellen, wobei die Vielzahl von Stromkompensationsschaltungen (206) konfiguriert ist, um einen wählbaren Strom von dem ersten Spannungsregler (210₁) zu ziehen, um die Rückflussdämpfung zu verbessern, wobei für jede der Vielzahl von Schaltungen (206₁ bis 206_{M}, 1202₁ bis 1202_{M}, 1204₁ bis 1204_{M}) ein Gate eines ersten Transistors (M₁) gekoppelt ist, um ein Signal eines Freigabeeingangs (EN₁, Sel1, Sel₂) zu empfangen, ein Gate eines zweiten Transistors (M₂) gekoppelt ist, um ein Signal eines ersten Vorspannungseingangs (V₁, Vorspannung2) zu empfangen, ein Gate des dritten Transistors (M₃) gekoppelt ist, um ein Signal eines zweiten Vorspannungseingangs (V₂, Vorspannung1) zu empfangen, und der erste Transistor (M₁), der zweite Transistor (M₂) und der dritte Transistor (M₃) in Reihe verbunden sind;
wobei die Vielzahl von Ausgangsschaltungen (208) zwischen einem Differentialeingang (Inp, Inn) und einem Differentialausgang (Txp, Txn) und parallel zwischen einem ersten gemeinsamen Knoten (V_{refp}) und einem zweiten gemeinsamen Knoten (V_{refn}) gekoppelt ist, wobei jede der Vielzahl von Ausgangsschaltungen (208) eine Reihenkombination aus einem Paar von Freigabeschaltungen, einem Paar von Invertern (Mₚ₁, Mₚ₂, Mₙ₁, Mₙ₂) und einem Paar von Widerständen (Rₚ, Rₙ) umfasst, die zwischen dem Differentialeingang (Inn, Ipp) und dem Differentialausgang (Txp, Txn) gekoppelt sind; ein erster Transistor zwischen dem ersten gemeinsamen Knoten (V_{refp}) und ersten Source-Anschlüssen des Paars von Invertern (Mₚ₁, Mₚ₂, Mₙ₁, Mₙ₂) gekoppelt ist und ein zweiter Transistor zwischen dem zweiten gemeinsamen Knoten (V_{refn}) und zweiten Source-Anschlüssen des Paars von Invertern (Mₚ₁, Mₚ₂, Mₙ₁, Mₙ₂) gekoppelt ist.

13. Verfahren nach Anspruch 12, wobei das Verfahren ferner umfasst:
Deaktivieren mindestens einer der Vielzahl von Ausgangsschaltungen (208) und
Anpassen einer Gate-zu-Source-Spannung jedes des ersten Transistors und des zweiten Transistors in jeder der Vielzahl von Schaltungen (208) basierend auf einer Rückkopplung von einer ersten und einer zweiten Nachbildungsausgangsschaltung.

## Revendications

1. Circuit de pilotage, comprenant :
une pluralité de circuits de sortie (208) couplés entre une entrée différentielle (202) et une sortie différentielle (Txp, Txn) et en parallèle entre un premier nœud commun (V_{refp}) et un second nœud commun (V_{refn}), chacun parmi la pluralité de circuits de sortie (208) comprenant :
une combinaison en série d'une paire d'inverseurs (Mₚ₁, Mₚ₂, Mₙ₁, Mₙ₂) et d'une paire de résistances (Rₚ, Rₙ), couplée entre l'entrée différentielle (Inp, Inn) et la sortie différentielle (Txp, Txn) ;
des premières bornes de source de la paire d'inverseurs (Mₚ₁, Mₚ₂, Mₙ₁, Mₙ₂) couplées au premier nœud commun (V_{refp}) ; et
des secondes bornes de source de la paire d'inverseurs (Mₚ₁, Mₚ₂, Mₙ₁, Mₙ₂) couplées au second nœud commun (V_{refn}) ;
un premier régulateur de tension (210₁) ayant une sortie couplée au premier nœud commun (V_{refp}) de la pluralité de circuits de sortie ;
un second régulateur de tension (210₂) ayant une sortie couplée au second nœud commun (V_{refn}) de la pluralité de circuits ; et
un circuit de compensation de courant (206, 1150) comprenant une pluralité de circuits (206₁ - 206_{M}, 1202₁-1202ₘ, 1204₁-1204ₘ) couplés en parallèle entre le premier nœud commun (V_{refp}) et le second nœud commun (V_{refn}) pour fournir un trajet de courant entre les sorties du premier régulateur de tension (210₁) et du second régulateur de tension (210₂), le circuit de compensation de courant (206) étant configuré pour prélever un courant sélectionnable auprès du premier régulateur de tension (210-1) pour améliorer une perte de retour, dans lequel, pour chacun parmi la pluralité de circuits (206₁-206_{M}, 1202₁-1202_{M}, 1204₁-1204_{M}), une grille d'un premier transistor (M₁) est couplée pour recevoir un signal d'une entrée de validation (EN₁, Sel1, Sel₂), une grille d'un deuxième transistor (M₂) est couplée pour recevoir un signal d'une première entrée de polarisation (V₁, Bias2), une grille du troisième transistor (M₃) est couplée pour recevoir un signal d'une seconde entrée de polarisation (V₂, Bias1), et le premier transistor (M₁) le deuxième transistor (M₂) et le troisième transistor (M₃) sont connectés en série.

2. Circuit de pilotage selon la revendication 1, dans lequel le premier régulateur de tension (210₁) comprend :
un premier transistor (M_{vrefp}) couplé entre une source de tension d'alimentation et le premier nœud commun (V_{refp}) de la pluralité de circuits de sortie ; et
un premier amplificateur opérationnel (A_{vrefp}) ayant une première entrée couplée à une première source de tension de référence, une seconde entrée couplée au premier nœud commun de la pluralité de circuits de sortie, et une sortie couplée à une grille du premier transistor.

3. Circuit de pilotage selon la revendication 2, dans lequel le second régulateur de tension (210₂) comprend :
un deuxième transistor (M_{vrefn}) couplé entre une source de masse et le second nœud commun de la pluralité de circuits de sortie ; et
un second amplificateur opérationnel (A_{vrefn}) ayant une première entrée couplée à une seconde source de tension de référence, une seconde entrée couplée au second nœud commun de la pluralité de circuits de sortie, et une sortie couplée à une grille du deuxième transistor.

4. Circuit de pilotage selon la revendication 1, dans lequel le second régulateur de tension (210₂) comprend :
un transistor de sortie (M_{power}) qui comporte une source couplée à un premier nœud d'alimentation de tension et un drain couplé à un nœud de sortie ;
un premier transistor (M_{SF1}) qui comporte une source couplée au nœud de sortie ;
un deuxième transistor (M_{SF2}) qui comporte une source couplée à une grille du transistor de sortie et un drain couplé à un second nœud d'alimentation de tension ;
une résistance (R₁) couplée entre le second nœud d'alimentation de tension et un premier nœud qui comporte le drain du premier transistor (M_{SF1}) et une grille du deuxième transistor (M_{SF2}) ; et
un amplificateur d'erreur (702) qui comporte une première entrée couplée à un nœud de tension de référence, une seconde entrée couplée au nœud de sortie, et une sortie couplée à une grille du premier transistor.

5. Circuit de pilotage selon la revendication 4, dans lequel l'amplificateur d'erreur (702) comporte un amplificateur cascode replié qui comporte : une paire de transistors à couplage à la source, qui comporte un nœud source couplé à une source de courant (I_{bais2}) et des drains couplés à un circuit de sortie, dans lequel le circuit de sortie est disposé entre le premier nœud d'alimentation de tension et le second nœud d'alimentation de tension, et dans lequel des grilles de la paire de transistors à couplage à la source sont couplées au nœud de tension de référence (V_{ref}) et au nœud de sortie (Vₒᵤₜ), respectivement.

6. Circuit de pilotage selon la revendication 1, dans lequel le circuit de compensation de courant (206) comporte :
un commutateur (1210) couplé en série avec une source de courant (1212), la combinaison en série du commutateur (1210) et de la source de courant (1212) étant couplée entre le premier nœud commun (Vrefp) et le second nœud commun (Vrefn) ; et
un détecteur d'événement (1220) couplé au commutateur pour alimenter un signal d'activation, le détecteur d'événement (1220) étant configuré pour commander un état du signal d'activation en fonction de la présence d'un motif dans une pluralité de signaux logiques générés par un filtre (914) couplé à la pluralité de circuits de sortie.

7. Circuit de pilotage selon la revendication 6, dans lequel :
la source de courant (1212) comporte une pluralité de circuits de source de courant (1212₁ - 1212_{M}) et le commutateur (1210) comporte une pluralité de circuits de commutation (1210₁ - 1210_{M}) couplés respectivement en série avec la pluralité de circuits de source de courant (1212₁ - 1212_{M}) ;
le signal d'activation est un signal d'activation commun ; et
chacun parmi la pluralité de circuits de commutation (1210₁ - 1210_{M}) réagit au signal d'activation commun et à un respectif parmi une pluralité de signaux d'activation individuels.

8. Circuit de pilotage selon la revendication 7, dans lequel chacun parmi la pluralité de circuits de commutation (1210₁ - 1210_{M}) comporte :
un transistor couplé en série avec un respectif parmi la pluralité de circuits de source de courant (1212₁ - 1212_{M}) et une grille logique (1222) couplée à une grille du transistor, la grille logique (1222) ayant une première entrée couplée pour recevoir le signal d'activation commun et une seconde entrée couplée pour recevoir un respectif parmi la pluralité de signaux d'activation individuels.

9. Circuit de pilotage selon la revendication 8, dans lequel chacun parmi la pluralité de circuits de source de courant (1212₁ - 1212_{M}) de la source de courant (1212) comporte :
un premier transistor en série avec un deuxième transistor, le premier transistor comportant une grille couplée à un premier nœud de polarisation et le deuxième transistor comportant une grille couplée à un second nœud de polarisation.

10. Circuit de pilotage selon la revendication 1, comprenant en outre :
un premier condensateur (C_{vrefp}) couplé entre le premier nœud commun (V_{refp}) de la pluralité de circuits de sortie et une source de masse ; et
un second condensateur (C_{vrefn}) couplé entre le second nœud commun de la pluralité de circuits de sortie et la source de masse.

11. Circuit de pilotage selon la revendication 1, dans lequel la sortie différentielle (Txp, Txn) de la pluralité de circuits de sortie est couplée à une paire de lignes de transmission (212ₚ, 212ₙ).

12. Procédé de commande d'un circuit de pilotage dans un transmetteur, comprenant :
la réception d'une pluralité de sorties d'un égaliseur dans le transmetteur ;
le couplage de chacune parmi la pluralité de sorties de l'égaliseur à au moins l'un parmi une pluralité de circuits de sortie (208) du circuit de pilotage ;
le couplage de sorties de premier et second régulateurs de tension (210₁, 210₂) à la pluralité de circuits de sortie (208) par l'intermédiaire d'un premier nœud commun (V_{refp}) et d'un second nœud commun (V_{refn}) et l'activation du second régulateur de tension (210₂) ; et
l'activation d'au moins l'un parmi une pluralité de circuits de compensation de courant (206) couplés en parallèle entre le premier nœud commun (V_{refp}) et un second nœud commun (V_{refn}) pour fournir un trajet de courant entre les sorties des premier et second régulateurs de tension (210₁, 210₂), la pluralité de circuits de compensation de courant (206) étant configurés pour prélever un courant sélectionnable provenant du premier régulateur de tension (210₁) pour améliorer une perte de retour, dans lequel, pour chacun parmi la pluralité de circuits (206₁-206_{M}, 1202₁-1202_{M}, 1204₁-1204_{M}), une grille d'un premier transistor (M₁) est couplée pour recevoir un signal d'une entrée d'activation (EN₁, Sel1, Sel₂), une grille d'un deuxième transistor (M₂) est couplée pour recevoir un signal d'une première entrée de polarisation (V₁, Bias2), une grille du troisième transistor (M₃) est couplée pour recevoir un signal d'une seconde entrée de polarisation (V₂, Bias1), et le premier transistor (M₁), le deuxième transistor (M₂) et le troisième transistor (M₃) sont connectés en série ;
dans lequel la pluralité de circuits de sortie (208) est couplée entre une entrée différentielle (Inp, Inn) et une sortie différentielle (Txp, Txn) et en parallèle entre un premier nœud commun (V_{refp}) et un second nœud commun (V_{refn}), dans lequel chacun parmi la pluralité de circuits de sortie (208) comprend une combinaison en série d'une paire de circuits d'activation, d'une paire d'inverseurs (Mₚ₁, Mₚ₂, Mₙ₁, Mₙ₂) et d'une paire de résistances (Rₚ, Rₙ), couplée entre l'entrée différentielle (Inn, Ipp) et la sortie différentielle (Txp, Txn) ; un premier transistor couplé entre le premier nœud commun (V_{refp}) et des premières bornes de source de la paire d'inverseurs (Mₚ₁, Mₚ₂, Mₙ₁, Mₙ₂) ; et un deuxième transistor couplé entre le second nœud commun (V_{refn}) et des secondes bornes de source de la paire d'inverseurs (Mₚ₁, Mₚ₂, Mₙ₁, Mₙ₂).

13. Procédé selon la revendication 12, dans lequel le procédé comprend en outre :
la désactivation d'au moins l'un parmi la pluralité de circuits de sortie (208) ; et
l'ajustement d'une tension de grille-vers-source de chacun du premier transistor et du deuxième transistor dans chacun parmi la pluralité de circuits (208) en fonction d'une rétroaction provenant de premier et second circuits de sortie de réplique.
